(19) Europäisches Patentamt
European Patent Office
Office européen des brevets

(11) **EP 4 203 287 A1**

(12) **DEMANDE DE BREVET EUROPEEN**

(43) Date de publication:
**28.06.2023 Bulletin 2023/26**

(21) Numéro de dépôt: **22214904.9**

(22) Date de dépôt: **20.12.2022**

(51) Classification Internationale des Brevets (IPC):
**H02M 3/335** (2006.01)    **H02M 3/00** (2006.01)

(52) Classification Coopérative des Brevets (CPC):
**H02M 3/33573; H02M 3/01; H02M 3/33571;
H02M 3/33584;** H02M 1/0058; H02M 1/342;
H02M 1/346; H02M 3/33561

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **21.12.2021 FR 2114117**

(71) Demandeur: **Commissariat à l'énergie atomique
et aux énergies alternatives
75015 Paris (FR)**

(72) Inventeurs:
• **DESPESSE, Ghislain
38054 GRENOBLE CEDEX 9 (FR)**
• **TOUHAMI, Mustapha
38054 GRENOBLE CEDEX 9 (FR)**
• **BRETON, Valentin
38054 GRENOBLE CEDEX 9 (FR)**

(74) Mandataire: **Lavoix
2, place d'Estienne d'Orves
75441 Paris Cedex 09 (FR)**

(54) **SYSTÈME DE CONVERSION D'ÉNERGIE ÉLECTRIQUE AVEC ENSEMBLE(S) PIÉZOÉLECTRIQUE(S) ET TRANSFORMATEUR ÉLECTRIQUE**

(57)    Ce système de conversion d'énergie électrique (5) comprend :
- un convertisseur (10) comportant E premier(s) ensemble(s) de commutation (30), chacun associé à une tension d'entrée et comportant deux premiers interrupteurs (36) ; N deuxième(s) ensemble(s) de commutation (40), chacun associé à une tension de sortie et comportant deux deuxièmes interrupteurs (46) ; et au moins un ensemble piézoélectrique (12) connecté à un interrupteur ; E≥1, N≥1 ;
- un dispositif de pilotage (20) configuré pour commander, lors d'un cycle de résonance, une commutation des interrupteurs pour alterner des phases à tension constante et des phases à charge constante aux bornes dudit/desdits ensembles piézoélectriques.

Le convertisseur (10) comprend un transformateur électrique (80) comportant un enroulement primaire (82) relié à un premier ensemble de commutation et un enroulement secondaire (84) relié à un deuxième ensemble de commutation, et chaque ensemble piézoélectrique est connecté entre un interrupteur et un enroulement.

FIG.1

**Description**

La présente invention concerne un système électronique de conversion d'énergie électrique apte à convertir une ou plusieurs tensions d'entrée en une ou plusieurs tensions de sortie, le système de conversion comprenant un convertisseur d'énergie électrique configuré pour délivrer N tension(s) de sortie distincte(s), à partir de E tension(s) d'entrée distincte(s), E et N étant chacun un nombre entier supérieur ou égal à 1, le convertisseur comportant E premier(s) ensemble(s) de commutation, chacun étant associé à une tension d'entrée respective et comportant au moins deux premiers interrupteurs, chaque premier interrupteur étant connecté à une borne d'application de la tension d'entrée respective ; N deuxième(s) ensemble(s) de commutation, chacun étant associé à une tension de sortie respective et comportant au moins deux deuxièmes interrupteurs, chaque deuxième interrupteur étant connecté à une borne de fourniture de la tension de sortie respective ; et au moins un ensemble piézoélectrique, chacun étant connecté à un interrupteur parmi les premiers et deuxièmes interrupteurs, et comportant au moins un élément piézoélectrique.

Le système de conversion comprend également un dispositif électronique de pilotage du convertisseur d'énergie électrique, le dispositif électronique de pilotage étant configuré pour commander, lors d'un cycle respectif de résonance du ou des ensembles piézoélectriques, une commutation de chacun des premiers et deuxièmes interrupteurs pour alterner des phases à tension sensiblement constante aux bornes du ou des ensembles piézoélectriques et des phases à charge sensiblement constante aux bornes dudit ou desdits ensembles piézoélectriques.

L'invention concerne le domaine des systèmes électroniques de conversion d'énergie électrique, en particulier ceux comportant un élément piézoélectrique, notamment des systèmes de conversion en une énergie électrique continue, c'est-à-dire les systèmes de conversion continu-continu, également appelés systèmes de conversion DC-DC (de l'anglais *Direct Current - Direct Current),* et les systèmes de conversion alternatif-continu, également appelés systèmes de conversion AC-DC (de l'anglais *Alternating Current - Direct Current).*

On connait des documents FR 3 086 471 A1 et FR 3 086 472 A1, ainsi que du manuscrit de thèse « Convertisseurs DC-DC piézoélectrique avec stockage provisoire d'énergie sous forme mécanique » de Benjamin POLLET, un convertisseur d'énergie électrique du type précité, visible sur la figure 20 des documents FR 3 086 471 A1 et FR 3 086 472 A1, et sur la figure 4.15 du manuscrit de thèse précité.

Les interrupteurs des premier et deuxième ponts de commutation sont commandés de façon cyclique, à la fréquence principale d'oscillation des ensembles piézoélectriques autour de leur mode de résonance présélectionné avec, entre chaque fermeture d'interrupteur(s), une phase dans laquelle le ou les ensembles piézoélectriques sont en circuit ouvert via l'ouverture d'au moins un interrupteur. La fermeture de chaque interrupteur s'effectue avantageusement sous une tension approximativement nulle à ses bornes, et dans tous les cas, la fermeture d'un interrupteur n'engendre jamais une variation importante de tension aux bornes du ou des ensembles piézoélectriques (inférieure à 20%, et avantageusement inférieure à 10%, de la tension d'entrée $V_{in}$ ou de la tension de sortie $V_{out}$).

En régime établi, un cycle de commande comporte typiquement six phases distinctes successives, à savoir trois phases à tension sensiblement constante aux bornes de chaque élément piézoélectrique et trois phases à charge sensiblement constante aux bornes dudit élément piézoélectrique, avec une alternance entre phases à tension sensiblement constante et phases à charge sensiblement constante.

Comme indiqué dans le document FR 3 086 471 A1 ou encore dans le manuscrit de thèse, un avantage qu'il y a à utiliser deux éléments piézoélectriques est que la tension de sortie est ainsi isolée de la tension d'entrée, sans pour autant qu'il soit nécessaire d'utiliser un transformateur.

L'isolation est capacitive et ne se fait donc pas avec un transformateur qui est source de pertes, mais par le fait que l'impédance du résonateur piézoélectrique est très élevée en basse fréquence et bloque toute propagation de tension à basse fréquence de l'entrée vers la sortie et inversement, notamment la composante éventuelle de mode commun égale à la moitié de la somme des potentiels en les bornes de fourniture de la tension de sortie moins la moitié de la somme des potentiels en les bornes d'application de la tension d'entrée. En effet, chaque élément piézoélectrique est modélisé sous forme d'un condensateur et d'une branche résonante connectée en parallèle du condensateur, la capacité dudit condensateur étant appelée capacité parallèle, ou encore capacité de référence, et notée $C_0$. Un signal basse fréquence de type 50/60 Hz sera alors filtré par la haute impédance (par exemple 3,1 MΩ pour $C_0$ = 1 nF à 50 Hz) de chacune des capacités bloquées des deux résonateurs piézoélectriques créant ainsi une isolation entre les parties entrées et sortie du convertisseur.

Cet avantage est présent même par rapport à un transformateur piézoélectrique, dans lequel toute l'énergie apportée au primaire n'est pas complètement transmise au secondaire et le primaire doit par ailleurs mettre en mouvement une masse plus grande, à savoir celle du primaire plus celle du secondaire, ce qui engendre des pertes.

Toutefois, le fonctionnement d'un tel convertisseur n'est pas optimal.

Le but de l'invention est alors de proposer un système de conversion comprenant un convertisseur d'énergie électrique avec au moins un ensemble piézoélectrique, et un dispositif de pilotage du convertisseur d'énergie électrique, le système permettant un meilleur fonctionnement du convertisseur.

A cet effet, l'invention a pour objet un système électronique de conversion d'énergie électrique apte à convertir une ou plusieurs tensions d'entrée en une ou plusieurs tensions de sortie, le système de conversion comprenant :

- un convertisseur d'énergie électrique configuré pour délivrer N tension(s) de sortie distincte(s), à partir de E tension(s) d'entrée distincte(s), E et N étant chacun un nombre entier supérieur ou égal à 1, le convertisseur comprenant :

  + E premier(s) ensemble(s) de commutation, chacun étant associé à une tension d'entrée respective et comportant au moins deux premiers interrupteurs, chaque premier interrupteur étant connecté à une borne d'application de la tension d'entrée respective ;
  + N deuxième(s) ensemble(s) de commutation, chacun étant associé à une tension de sortie respective et comportant au moins deux deuxièmes interrupteurs, chaque deuxième interrupteur étant connecté à une borne de fourniture de la tension de sortie respective ;
  + au moins un ensemble piézoélectrique, chacun étant connecté à un interrupteur parmi les premiers et deuxièmes interrupteurs, et comportant au moins un élément piézoélectrique ;

- un dispositif électronique de pilotage du convertisseur d'énergie électrique, le dispositif électronique de pilotage étant configuré pour commander, lors d'un cycle respectif de résonance du ou des ensembles piézoélectriques, une commutation de chacun des premiers et deuxièmes interrupteurs pour alterner des phases à tension sensiblement constante aux bornes du ou des ensembles piézoélectriques et des phases à charge sensiblement constante aux bornes dudit ou desdits ensembles piézoélectriques,

le convertisseur comprenant en outre un transformateur électrique comportant, au moins un enroulement primaire et au moins un enroulement secondaire, chaque enroulement primaire étant relié à un premier ensemble de commutation, chaque enroulement secondaire étant relié à un deuxième ensemble de commutation, et chaque ensemble piézoélectrique est connecté entre un interrupteur et un enroulement respectifs.

Avec le système de conversion d'énergie selon l'invention, le transformateur électrique autorise des rapports de conversion bien plus élevés qu'avec le système de conversion de l'état de la technique, de par le rapport de transformation entre les enroulements secondaire et primaire, la valeur de la tension pendant au moins une phase à tension sensiblement constante aux bornes du ou des ensembles piézoélectriques, c'est-à-dire la valeur d'au moins un palier de tension, dépendant alors d'une tension de sortie respective multipliée par ce rapport de transformation.

Le transformateur électrique associé au(x) ensemble(s) piézoélectrique(s) permet en outre d'assurer plusieurs niveaux d'isolation successifs, et par exemple offrir une meilleure isolation pour des systèmes critiques.

L'homme du métier observera en outre qu'il existe une complémentarité entre ces deux isolations. En cas de commande ou d'interrupteur défaillant, au primaire ou au secondaire, l'enroulement primaire ou secondaire du transformateur électrique pourrait être sur le chemin d'un court-circuit, mais grâce au(x) ensemble(s) piézoélectrique(s) qui bloquent les composantes basse fréquence, ce court-circuit est naturellement ouvert, ce qui évite un échauffement du transformateur électrique et une défaillance de ce dernier qui pourrait par ailleurs engendrer des risques électriques pour l'utilisateur.

En outre, l'utilisation de deux types différents d'isolation renforce l'isolation et la sécurité, au sens où il faudrait deux défauts de nature différente pour engendrer un risque de perte de l'isolement, ce qui est moins probable que deux défauts de même nature qui pourraient apparaitre en même temps suite à un même type de stress (T°, humidité...).

De plus, l'ajout d'une isolation piézoélectrique est susceptible de permettre d'alléger des contraintes pesant sur le transformateur électrique, telles que l'éloignement de spires primaire et secondaire, ou encore l'épaisseur de vernis ; et ainsi gagner en coût et/ou en rendement.

De préférence, l'agencement d'au moins un ensemble piézoélectrique en amont du transformateur électrique permet de réduire, voire de supprimer, la composante continue éventuelle aux bornes de l'enroulement primaire du transformateur électrique, et d'améliorer alors encore son fonctionnement.

L'homme du métier observera qu'un transformateur électrique seul, sans être combiné à un ou plusieurs ensembles piézoélectriques, ne permet de faire qu'un rapport de tension fixe entre l'entrée et la sortie. Pour pouvoir ajuster librement la tension de sortie, il est possible de rajouter un élément inductif (type convertisseur LLC, dual bridge).

Néanmoins, le système de conversion selon l'invention combinant avec le transformateur électrique au moins un ensemble piézoélectrique offre l'avantage de présenter moins de pertes (facteur de qualité plus élevé) et d'être plus compact (plus grande densité d'énergie stockable par unité de volume) et aussi de pouvoir supporter une composante continue de tension.

Suivant d'autres aspects avantageux de l'invention, le système électronique de conversion d'énergie comprend une ou plusieurs des caractéristiques suivantes, prises isolément ou suivant toutes les combinaisons techniquement possibles :

- chaque ensemble piézoélectrique est connecté entre un premier interrupteur et un enroulement primaire ou bien entre un deuxième interrupteur et un enroulement secondaire ;

- chaque enroulement est connecté à au moins un ensemble piézoélectrique ou bien présente entre ses extrémités une tension de valeur moyenne sensiblement nulle sur un cycle respectif de résonance, le dispositif de pilotage étant alors configuré pour commander les interrupteurs de l'ensemble de commutation connecté audit enroulement de manière à obtenir ladite tension de valeur moyenne sensiblement nulle ;
- le convertisseur comprend plusieurs ensembles piézoélectriques, et chaque enroulement est connecté à au moins un ensemble piézoélectrique ;
- le convertisseur comprend un seul ensemble piézoélectrique connecté à un enroulement respectif, et le ou chaque autre enroulement présente entre ses extrémités une tension de valeur moyenne sensiblement nulle sur un cycle respectif de résonance ;
- au moins un premier ensemble de commutation est en forme d'un premier pont de commutation comportant au moins une première branche de commutation, chaque première branche de commutation étant connectée entre deux bornes d'application d'une tension d'entrée respective et comportant au moins deux premiers interrupteurs connectés en série et reliés entre eux en un premier point milieu ;

chaque premier ensemble de commutation étant de préférence en forme d'un premier pont de commutation respectif ;

- au moins un premier ensemble de commutation comporte deux premières branches de commutation ;

chaque premier ensemble de commutation comportant de préférence deux premières branches de commutation ;

- un ensemble piézoélectrique est connecté entre un premier point milieu et un enroulement primaire respectif ;
- au moins un deuxième ensemble de commutation est en forme d'un deuxième pont de commutation comportant au moins une deuxième branche de commutation, chaque deuxième branche de commutation étant connectée entre deux bornes de fourniture d'une tension de sortie respective et comportant au moins deux deuxièmes interrupteurs connectés en série et reliés entre eux en un deuxième point milieu ;

chaque deuxième ensemble de commutation étant de préférence en forme d'un deuxième pont de commutation respectif ;

- au moins un deuxième ensemble de commutation comporte deux deuxièmes branches de commutation ;

chaque deuxième ensemble de commutation comportant de préférence deux deuxièmes branches de commutation ;

- un ensemble piézoélectrique est connecté entre un deuxième point milieu et un enroulement secondaire respectif ;
- un enroulement comporte, entre ses extrémités, au moins un point intermédiaire connecté à un ensemble de commutation respectif ou bien à une borne respective d'application de tension d'entrée ou de fourniture de tension de sortie ;
- le convertisseur comprend un couple d'ensembles piézoélectriques connectés à un même enroulement respectif, et en outre un interrupteur complémentaire connecté directement entre des extrémités dudit couple d'ensembles piézoélectriques, lesdites extrémités reliées directement entre elles via l'interrupteur complémentaire étant connectées à un même ensemble de commutation respectif ;
- le convertisseur comprend un couple d'ensembles piézoélectriques connectés à un même enroulement respectif, et en outre un circuit d'aide à la commutation connecté entre des extrémités dudit couple d'ensembles piézoélectriques, lesdites extrémités reliées entre elles via le circuit d'aide à la commutation étant connectées à un même ensemble de commutation respectif, le circuit d'aide à la commutation étant configuré pour, via la circulation d'un courant préalablement reçu, décharger une capacité parasite d'au moins un interrupteur de l'ensemble de commutation respectif auquel il est connecté, et respectivement charger au moins une capacité parasite d'un autre interrupteur dudit ensemble de commutation ;
- le circuit d'aide à la commutation comporte un élément choisi parmi le groupe consistant en : une inductance ; un premier ensemble formé d'une inductance et d'une diode connectées en série ; un deuxième ensemble formé d'une inductance et d'un condensateur connectés en série ; et un élément piézoélectrique additionnel ;

le circuit d'aide à la commutation étant de préférence constitué d'un élément choisi parmi ledit groupe ;
l'inductance étant de préférence encore en forme d'une inductance parasite de l'enroulement respectif auquel est connecté le couple d'ensembles piézoélectriques ;

- le transformateur électrique est un transformateur à air ou un transformateur magnétique, le transformateur magnétique comportant en outre un noyau magnétique, chaque enroulement étant alors agencé autour du noyau ;

le transformateur électrique étant par exemple un autotransformateur ;

- le convertisseur d'énergie électrique est configuré pour délivrer plusieurs tensions de sortie distinctes et comporte plusieurs deuxièmes ensembles de commutation, N étant un nombre entier supérieur ou égal à 2 ; et
- le convertisseur d'énergie électrique est configuré pour convertir plusieurs tensions d'entrée distinctes et comporte plusieurs premiers ensembles de commutation, E étant un nombre entier supérieur ou égal à 2.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

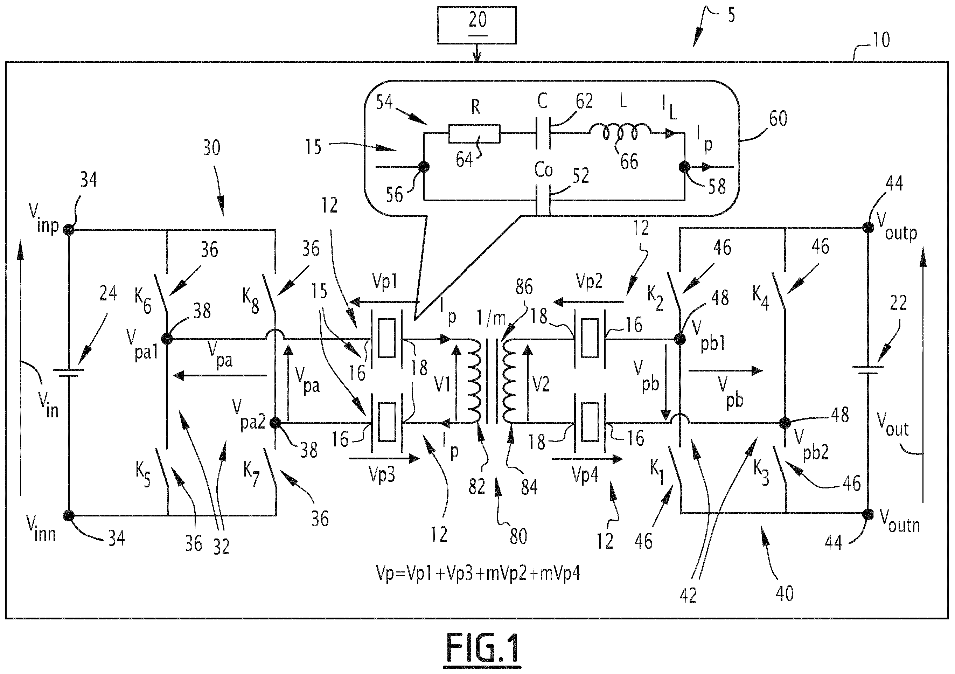

- la figure 1 est une représentation schématique d'un système électronique de conversion d'énergie électrique selon l'invention, comprenant un convertisseur d'énergie électrique et un dispositif électronique de pilotage dudit convertisseur, le convertisseur étant configuré pour délivrer N tension(s) de sortie à partir de E tension(s) d'entrée, et comportant E premier(s) ensemble(s) de commutation, chacun étant associé à une tension d'entrée respective et comportant au moins deux premiers interrupteurs, chaque premier interrupteur étant connecté à une borne d'application de la tension d'entrée respective ; N deuxième(s) ensemble(s) de commutation, chacun étant associé à une tension de sortie respective et comportant au moins deux deuxièmes interrupteurs, chaque deuxième interrupteur étant connecté à une borne de fourniture de la tension de sortie respective ; au moins un ensemble piézoélectrique, chacun étant connecté à un interrupteur parmi les premiers et deuxièmes interrupteurs ; et en outre un transformateur électrique comportant au moins un enroulement primaire et au moins un enroulement secondaire, chaque enroulement primaire étant relié à un premier ensemble de commutation, chaque enroulement secondaire étant relié à un deuxième ensemble de commutation, et chaque ensemble piézoélectrique est connecté entre un interrupteur et un enroulement respectifs ;
  E et N étant ici chacun égal à 1, le premier ensemble de commutation étant en forme d'un premier pont avec deux premières branches comportant chacune deux premiers interrupteurs, le deuxième ensemble de commutation étant en forme d'un deuxième pont avec deux deuxièmes branches comportant chacune deux deuxièmes interrupteurs, et le convertisseur comportant quatre ensembles piézoélectriques, chacun étant connecté à un point milieu d'une branche respective ;

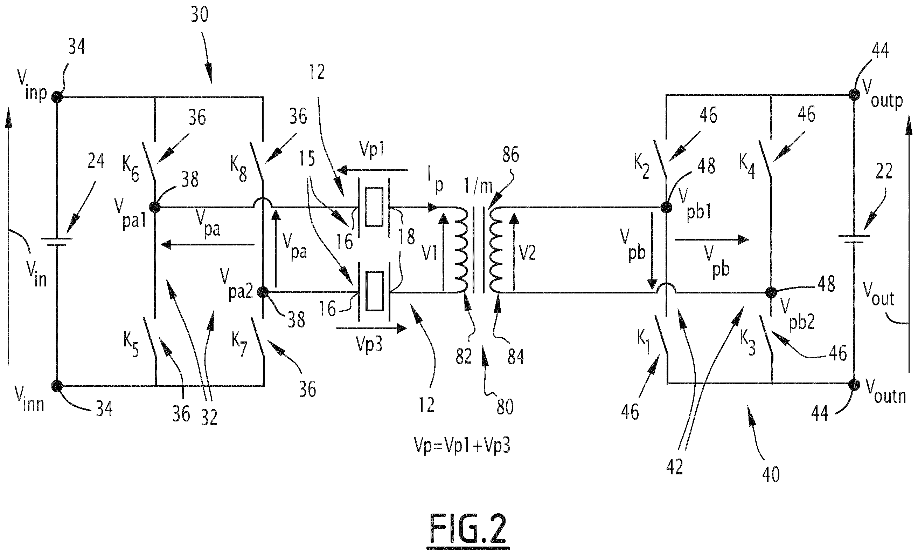

- la figure 2 est une vue analogue à celle de la figure 1, avec deux ensembles piézoélectriques, chacun étant connecté à un point milieu d'une première branche respective ;

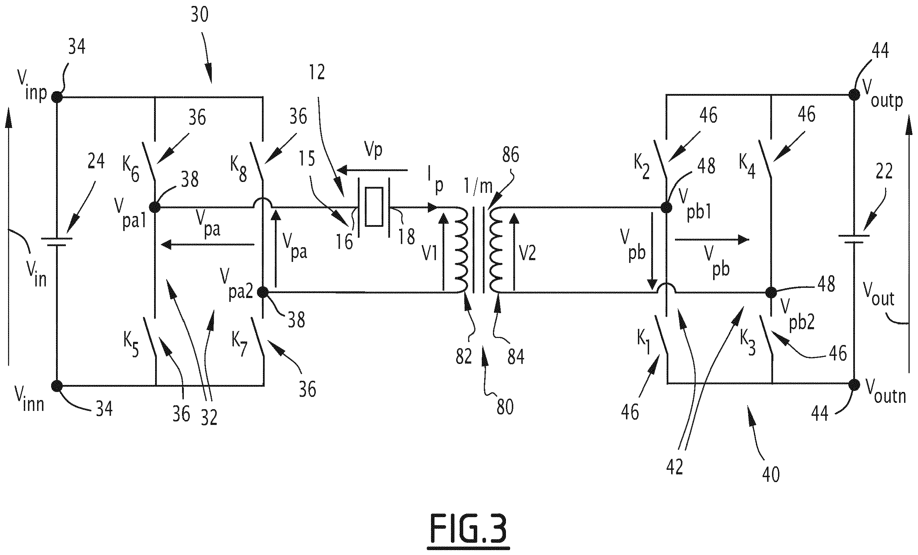

- la figure 3 est une vue analogue à celle de la figure 1, avec un seul ensemble piézoélectrique connecté à un point milieu d'une première branche respective ;

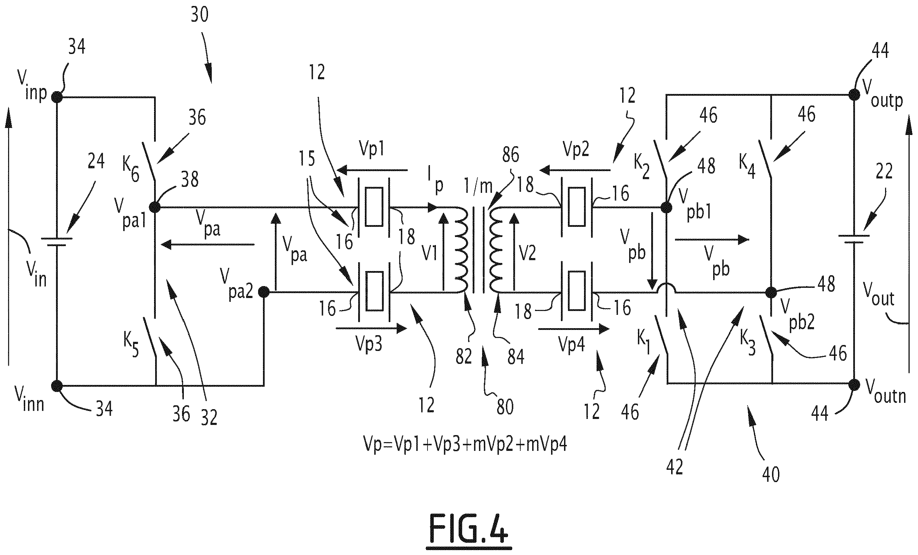

- la figure 4 est une vue analogue à celle de la figure 1, avec quatre ensembles piézoélectriques, où le premier ensemble de commutation comporte une seule première branche avec deux premiers interrupteurs, et avec au primaire un ensemble piézoélectrique connecté alors au point milieu de la première branche, et l'autre ensemble piézoélectrique connecté à une borne respective d'application de la tension d'entrée ;

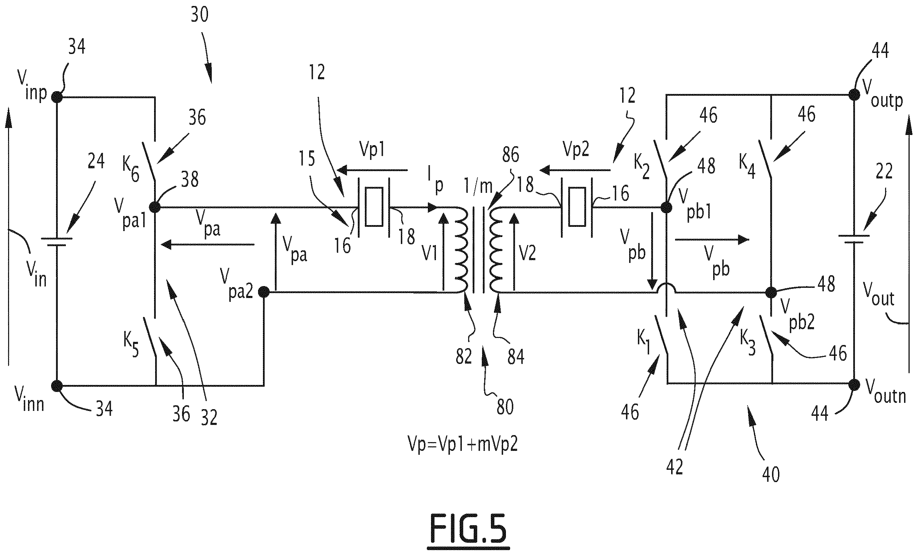

- la figure 5 est une vue analogue à celle de la figure 4, avec deux ensembles piézoélectriques, un ensemble piézoélectrique étant connecté au point milieu de la première branche, et l'autre ensemble piézoélectrique étant connecté à un point milieu d'une deuxième branche respective ;

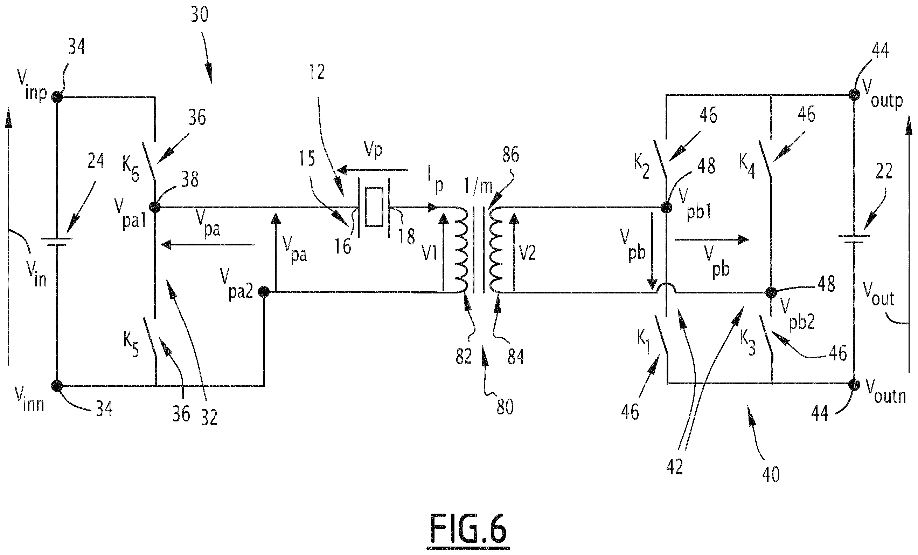

- la figure 6 est une vue analogue à celle de la figure 4, avec un seul ensemble piézoélectrique, connecté au point milieu de la première branche ;

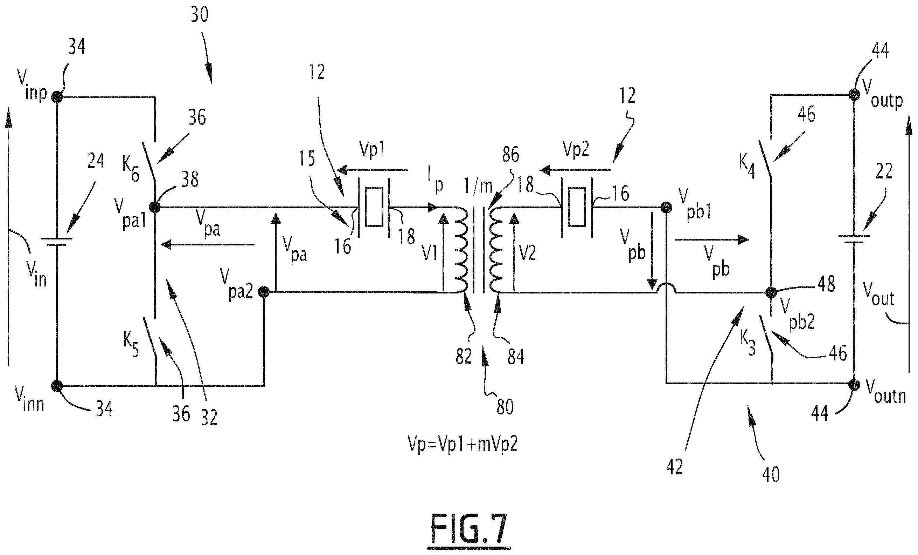

- la figure 7 est une vue analogue à celle de la figure 1, avec deux ensembles piézoélectriques, où le premier ensemble de commutation comporte une seule première branche avec deux premiers interrupteurs, et le deuxième ensemble de commutation comporte une seule deuxième branche avec deux deuxièmes interrupteurs ; un ensemble piézoélectrique étant connecté au point milieu de la première branche, et l'autre ensemble piézoélectrique étant connecté à une borne respective de fourniture de la tension de sortie ;

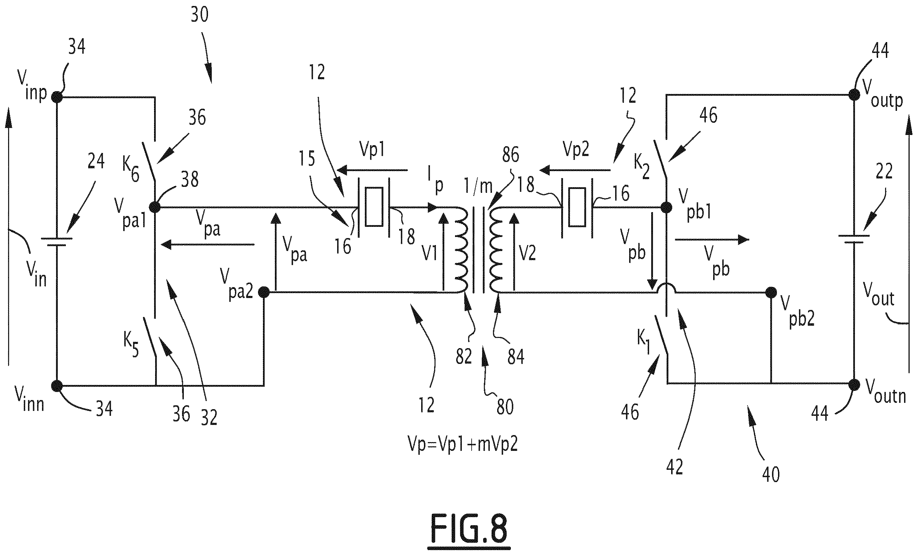

- la figure 8 est une vue analogue à celle de la figure 7, avec un ensemble piézoélectrique connecté au point milieu de la première branche, et l'autre ensemble piézoélectrique connecté au point milieu de la deuxième branche ;

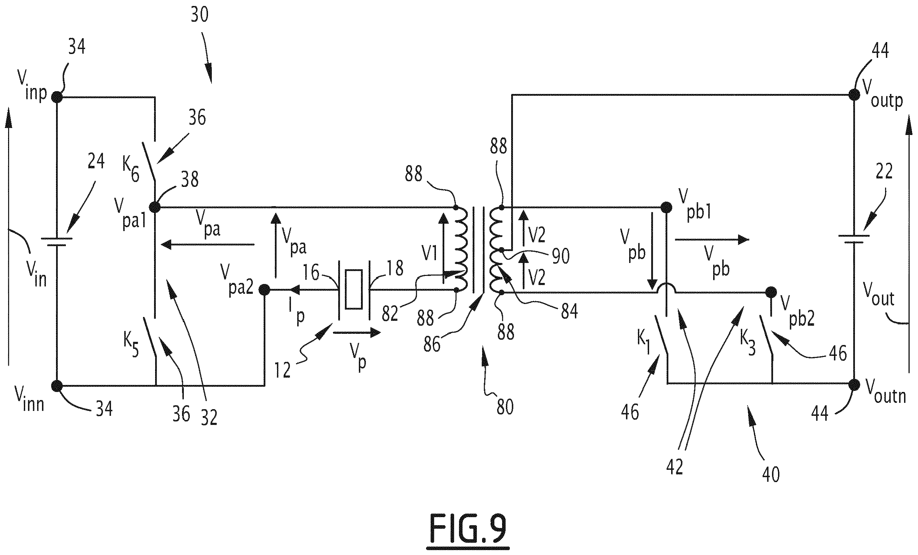

- la figure 9 est une vue analogue à celle de la figure 8, avec un seul ensemble piézoélectrique, connecté à une borne respective d'application de la tension d'entrée, et où l'enroulement secondaire comporte, entre ses extrémités, un point intermédiaire connecté à une borne respective de fourniture de la tension de sortie ;

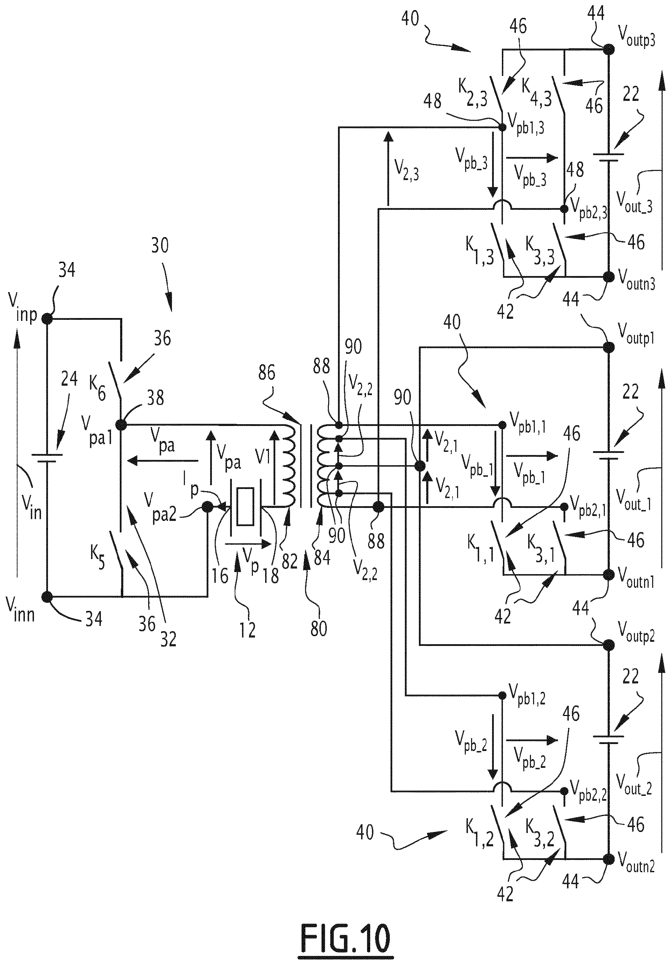

- la figure 10 est une vue analogue à celle de la figure 9, où E est égal à 1 et N est égal à 3 ; où l'enroulement secondaire comporte, entre ses extrémités, trois points intermédiaires connectés chacun à une borne respective de fourniture d'une tension de sortie respective ou à un deuxième ensemble de commutation respectif ;

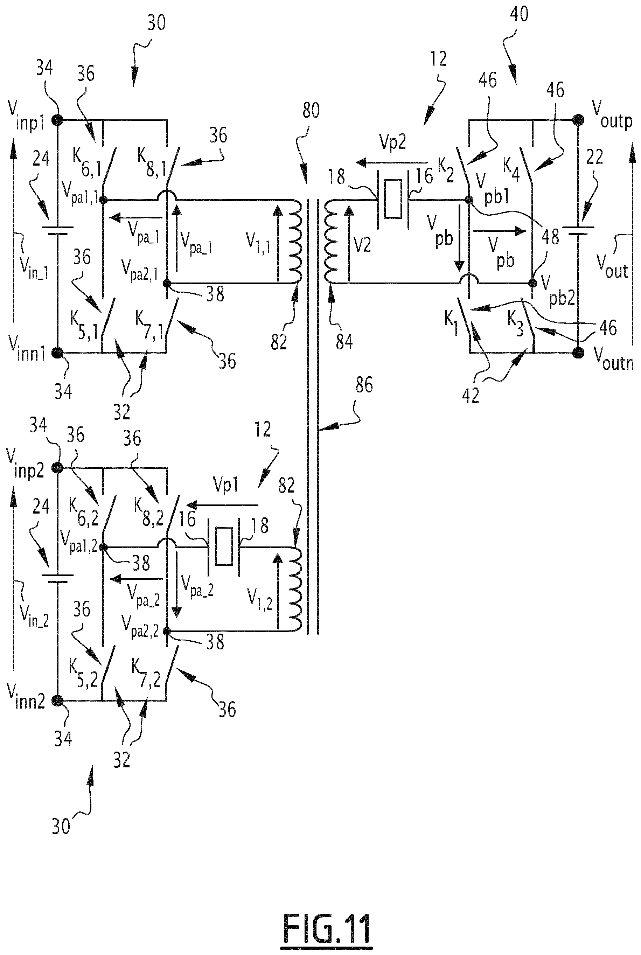

- la figure 11 est une vue analogue à celle de la figure 1, où E est égal à 2 et N est égal à 1 ; avec deux ensembles piézoélectriques, un ensemble piézoélectrique étant connecté au point milieu d'une première branche respective associée à l'une des tensions d'entrée, et l'autre ensemble piézoélectrique étant connecté à un point milieu d'une deuxième branche respective ;

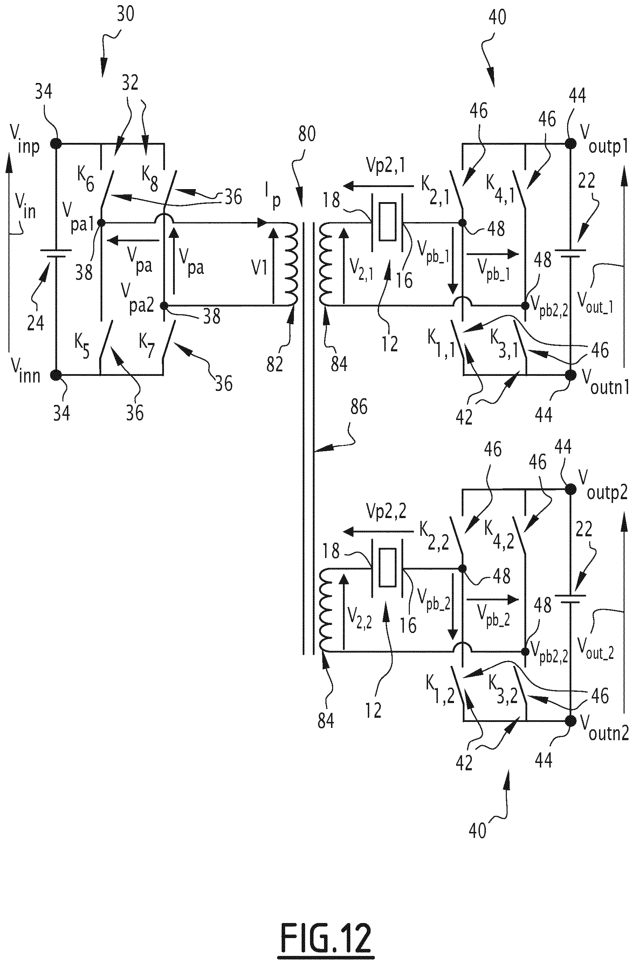

- la figure 12 est une vue analogue à celle de la figure 1, où E est égal à 1 et N est égal à 2 ; avec deux ensembles piézoélectriques, chacun étant connecté à un point milieu d'une deuxième branche respective ;

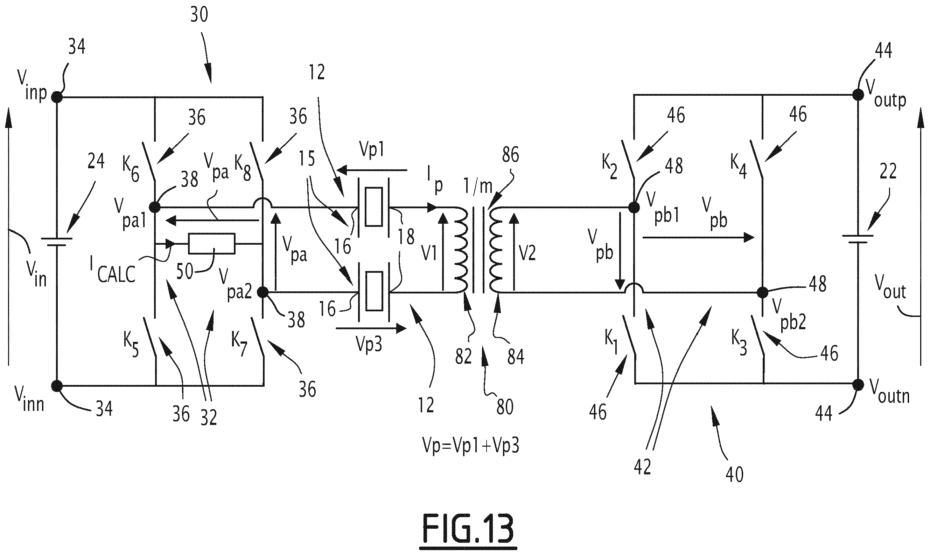

- la figure 13 est une vue analogue à celle de la figure 2, selon un aspect complémentaire où le convertisseur comprend en outre un circuit d'aide à la commutation connecté entre les points milieux des premières branches, i.e. entre les extrémités des deux ensembles piézoélectriques qui ne sont pas connectées à l'enroulement primaire ;

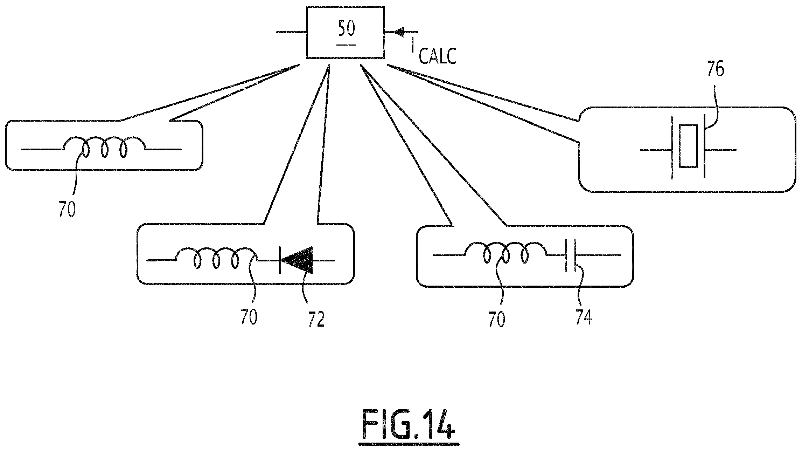

- la figure 14 est une représentation schématique de différents types de circuit d'aide à la commutation ; et

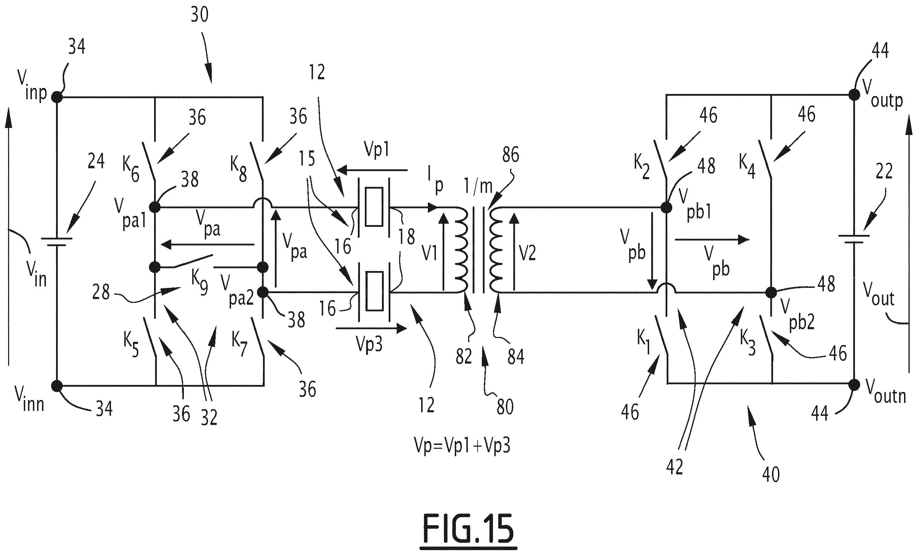

- la figure 15 est une vue analogue à celle de la figure 2, selon un aspect complémentaire où le convertisseur comporte en outre un interrupteur complémentaire connecté directement entre les points milieux des premières branches, i.e. entre les extrémités des deux ensembles piézoélectriques qui ne sont pas connectées à l'enroulement primaire.

L'expression « sensiblement égal(e) à » définit une relation d'égalité à plus ou moins 10%, de préférence à plus ou moins 5%.

Sur la figure 1, un système électronique de conversion d'énergie électrique 5 comprend un convertisseur d'énergie électrique 10 comportant au moins un ensemble piézoélectrique 12 d'au moins un élément piézoélectrique 15, plusieurs interrupteurs $K_1$, $K_2$, $K_3$, $K_4$, $K_5$, $K_6$, $K_7$, $K_8$ aptes à être commandés pour alterner des phases à tension sensiblement constante aux bornes du ou des ensembles piézoélectriques 12 et des phases à charge sensiblement constante aux bornes du ou des ensembles piézoélectriques 12 ; et un dispositif électronique 20 de pilotage du convertisseur d'énergie électrique 10. Chaque ensemble piézoélectrique 12 comporte une première extrémité 16 et une deuxième extrémité 18.

Par souci de simplification des dessins, le rectangle délimitant schématiquement le convertisseur d'énergie électrique 10 et le dispositif électronique de pilotage 20 sont représentés seulement sur la figure 1, et seul le contenu du convertisseur 10 est ensuite représenté sur les figures 2 à 13 et 15.

Le système électronique de conversion d'énergie électrique 5 est typiquement un système de conversion en une énergie électrique continue, tel qu'un système de conversion continu-continu apte à convertir une première énergie ou tension électrique continue reçue en entrée en une deuxième énergie ou tension électrique continue délivrée en sortie, ou encore un système de conversion alternatif-continu apte à convertir une énergie ou tension électrique alternative reçue en entrée en une énergie ou tension électrique continue délivrée en sortie du système de conversion 5.

Lorsque le système de conversion d'énergie électrique 5 est un système de conversion alternatif-continu, le système de conversion d'énergie électrique 5 comprend de préférence en outre un redresseur de tension, non représenté, connecté en entrée du convertisseur d'énergie électrique 10 et apte à redresser la tension électrique alternative reçue en entrée du système de conversion 5 pour délivrer une tension électrique redressée en entrée du convertisseur 10, le convertisseur d'énergie électrique 10 étant de préférence un convertisseur continu-continu apte à convertir une énergie ou tension électrique continue en une autre énergie ou tension électrique continue. Le redresseur de tension est par exemple un pont redresseur, tel qu'un pont de diodes. En variante, le redresseur de tension est formé en partie par des interrupteurs du convertisseur 10. Une tension électrique continue signifie une tension qui varie lentement au regard de la vitesse de variation de la tension aux bornes des ensembles piézoélectriques. Il s'agit de variations de tension qui évoluent typiquement à une fréquence au moins 10 fois inférieure à la fréquence d'oscillation mécanique du/des ensembles piézoélectriques 12.

L'homme du métier observera que ces différents exemples pour le système conversion 5, qu'il s'agisse d'un système de conversion continu-continu ou bien d'un système de conversion alternatif-continu, sont également présentés dans les documents FR 3 086 471 A1 et FR 3 086 472 A1, notamment en regard de leurs figures 1 et 2.

Le convertisseur d'énergie électrique 10 est de préférence un convertisseur continu-continu, et est également appelé convertisseur DC-DC. Le convertisseur continu-continu a généralement pour rôle de réguler une tension d'alimentation d'une charge 22 à une valeur stable, en étant alimenté par une source d'énergie 24 fournissant une tension sensiblement continue. La source d'énergie 24 est par exemple une batterie ou un panneau solaire.

Le convertisseur d'énergie électrique 10 est alors configuré pour élever la valeur de la tension continue entre son entrée et sa sortie, et est alors également appelé convertisseur continu-continu élévateur ; ou bien est configuré pour abaisser la valeur de la tension continue entre son entrée et sa sortie, et est alors appelé convertisseur continu-continu abaisseur.

Le convertisseur d'énergie électrique 10 est configuré pour délivrer N tension(s) de sortie distincte(s), à partir de E tension(s) d'entrée distincte(s), E et N étant chacun un nombre entier supérieur ou égal à 1.

Dans les exemples des figures 1 à 9, 13 et 15, le convertisseur d'énergie électrique 10 est configuré pour délivrer une tension de sortie, notée $V_{out}$, à partir d'une tension d'entrée, notée $V_{in}$, le nombre E de tension(s) d'entrée et le nombre N de tension(s) de sortie étant alors chacun égal à 1.

Dans les exemples des figures 10 et 12, le convertisseur d'énergie électrique 10 est configuré pour délivrer plusieurs tensions de sortie distinctes, notées $V_{out\_j}$ où j est un indice entier compris entre 1 et N, à partir de la tension d'entrée $V_{in}$, le nombre N de tensions de sortie distinctes étant alors supérieur à 1, en particulier égal à 3 dans l'exemple de la figure 10 et à 2 dans celui de la figure 12. Selon cet exemple, le convertisseur 10 est typiquement connecté à plusieurs charges 22, comme représenté sur les figures 10 et 12.

Dans l'exemple de la figure 11, le convertisseur d'énergie électrique 10 est configuré pour délivrer une tension de sortie, notée $V_{out}$, à partir de plusieurs tensions d'entrée distinctes, notées $V_{in\_k}$ où k est un indice entier compris entre 1 et E, le nombre E de tensions d'entrée distinctes étant alors supérieur à 1, en particulier égal à 2 dans l'exemple de la figure 11. Selon cet exemple, le convertisseur 10 est typiquement connecté à plusieurs sources 24, comme représenté sur la figure 11.

Le convertisseur d'énergie électrique 10 comporte un ou plusieurs ensembles piézoélectriques 12 formés chacun d'un ou plusieurs éléments piézoélectriques 15, et le dispositif de pilotage 20 est configuré pour faire fonctionner le matériau piézoélectrique des éléments piézoélectriques 15 à leur résonance afin d'exploiter des phases de transfert de charge permettant de s'affranchir de l'utilisation d'un élément inductif, tout en régulant la tension de sortie en conservant la résonance du matériau piézoélectrique, c'est-à-dire avec des cycles de commutation répétés à une fréquence de fonctionnement dépendant de la fréquence de résonance des éléments piézoélectriques 15, et en ajustant les durées entre les commutations respectives à l'intérieur du cycle de résonance.

En régime établi, le ou les ensembles piézoélectriques 12 échangent une charge et une puissance sensiblement nulle sur un cycle de résonance, aux pertes près. Autrement dit, chaque ensemble piézoélectrique 12 redonne, sensiblement autant qu'il reçoit, d'énergie et de charge sur une période. Deux conditions de fonctionnement s'appliquent alors au régime permanent/établi, à savoir l'équilibre de charge et l'équilibre d'énergie sur une période de résonance. Même si durant les transitoires (démarrage, variation des paliers de tension, changement du courant de sortie) cette équilibre n'est pas respecté, il faut néanmoins qu'il puisse être atteint en régime établi. Ceci impose notamment un certain agencement des paliers de tension durant la période de résonance. Par exemple, pour un fonctionnement à trois paliers de tension, les deux paliers de tension extrêmes sont commandés lors d'une demi-période d'une polarité donnée d'un courant $I_L$ circulant dans les éléments piézoélectriques 15, et le palier de tension intermédiaire est commandé lors de l'autre demi-période de polarité opposée du courant $I_L$ circulant dans les éléments piézoélectriques 15.

Comme connu en soi, l'oscillation mécanique des éléments piézoélectriques 15 est approximativement sinusoïdale. La déformation mécanique totale des éléments piézoélectriques 15 est la somme de déformations mécaniques élémentaires de chacun des éléments piézoélectriques 15.

Une augmentation ou une diminution de l'énergie stockée sur une période conduit respectivement à une augmentation ou à une diminution de l'amplitude d'oscillation. Par ailleurs, lors d'une phase à charge sensiblement constante aux bornes des ensembles piézoélectriques 12, c'est-à-dire lorsque les éléments piézoélectriques 15 sont placés dans un circuit électrique sensiblement ouvert, avec un faible échange de charges électriques entre les éléments piézoélectriques 15 et l'extérieur, une augmentation de l'amplitude des oscillations engendre une augmentation de la vitesse de variation de la tension $V_p$ aux bornes des ensembles piézoélectriques 12, et lors d'une phase à tension sensiblement constante aux bornes des ensembles piézoélectriques 12, cette augmentation d'amplitude d'oscillation conduit à une augmentation du courant $I_L$ circulant dans les éléments piézoélectriques 15.

Par charge sensiblement constante, on entend un échange d'une charge avec l'extérieur qui est inférieur à 10% de la charge qui aurait été échangée avec l'extérieur si la tension avait été maintenue constante. Autrement dit, par charge sensiblement constante, on entend une variation de charge inférieure à 10% de la charge qui aurait été échangée avec l'extérieur des ensembles piézoélectriques 12 si la tension aux bornes des ensembles piézoélectriques 12 avait été maintenue constante sur la durée temporelle considérée.

Par circuit électrique sensiblement ouvert, on entend un circuit dont un éventuel courant de fuite conduit à une variation de charge des ensembles piézoélectriques 12 inférieure à 10% de la charge qui aurait été échangée avec l'extérieur des ensembles piézoélectriques 12 si la tension aux bornes des ensembles piézoélectriques 12 avait été maintenue constante sur la durée temporelle considérée.

Par tension sensiblement constante, on entend une variation de tension inférieure à 20%, de préférence inférieure à 10%, de la tension d'entrée ou de sortie du convertisseur 10. À titre d'exemple, si la tension d'entrée du convertisseur 10 est égale à 100V, alors la variation de tension lors de chaque phase à tension sensiblement constante, c'est-à-dire sur chaque palier à tension sensiblement constante, est inférieure à 20% de cette tension, c'est-à-dire inférieure à 20V ; de préférence inférieure à 10 % de cette tension, c'est-à-dire inférieure à 10V. Chaque phase à tension sensiblement constante est également appelée palier de tension.

Le convertisseur 10 comporte alors plusieurs interrupteurs $K_1$, $K_2$, $K_3$, $K_4$, $K_5$, $K_6$, $K_7$, $K_8$ visibles au moins en partie sur les figures 1 à 9, 13 et 15, $K_{i,m}$ visibles sur les figures 10 à 12 (où i est un indice entier représentant un identifiant d'interrupteur, typiquement compris entre 1 et 8 dans les exemples des figures 10 à 12, et m est un indice entier représentant un identifiant de tension d'entrée, ou respectivement de tension de sortie, typiquement compris entre 1 et 3 dans les exemples des figures 10 à 12) aptes à être commandés pour alterner des phases à tension sensiblement constante et des phases à charge sensiblement constante aux bornes des ensembles piézoélectriques 12, à l'intérieur de périodes de durée sensiblement constante correspondant à la fréquence de fonctionnement du convertisseur 10, dépendant de la fréquence de résonance, également appelée fréquence propre, des éléments piézoélectriques 15. Les phases à charge sensiblement constante permettent, en régime établi ou permanent, de passer d'une tension constante à une autre et de fermer les interrupteurs qui doivent l'être lorsque la tension à leurs bornes est de préférence nulle afin d'avoir une commutation dite à zéro de tension, également appelée commutation en mode ZVS (de l'anglais *Zero Voltage Switching)*.

Le convertisseur 10 comprend E premier(s) ensemble(s) de commutation 30, chacun étant associé à une tension d'entrée respective $V_{in}$, $V_{in\_k}$ et comportant au moins deux premiers interrupteurs 36, chaque premier interrupteur 36 étant connecté à une borne 34 d'application de la tension d'entrée respective $V_{in}$, $V_{in\_k}$, où E est le nombre de tension(s) d'entrée distincte(s) $V_{in}$, $V_{in\_k}$, E étant supérieur ou égal à 1.

Dans les exemples des figures 1 à 13 et 15, les premiers interrupteurs 36 correspondent aux interrupteurs $K_5$, $K_6$, $K_7$, $K_8$ visibles au moins en partie sur les figures 1 à 9, 13 et 15, ou aux interrupteurs $K_{i,m}$ visibles sur les figures 10 à 12, avec i compris entre 5 et 8.

Dans les exemples des figures 1 à 10, 12, 13 et 15, où E est égal à 1, le convertisseur 10 comprend un seul premier ensemble de commutation 30 associé à la tension d'entrée Vin.

Dans l'exemple de la figure 11, où E est égal à 2, le convertisseur 10 comprend deux premiers ensembles de commutation 30, chacun étant associé à une tension d'entrée respective $V_{in\_1}$, $V_{in\_2}$.

En complément facultatif, au moins un premier ensemble de commutation 30 est en forme d'un premier pont de commutation comportant au moins une première branche de commutation 32, chaque première branche de commutation 32 étant connectée entre deux bornes 34 d'application d'une tension d'entrée respective $V_{in}$, $V_{in\_k}$ et comportant au moins deux premiers interrupteurs 36 connectés en série et reliés entre eux en un premier point milieu 38. Chaque première branche de commutation 32 est de préférence constituée des deux premiers interrupteurs 36.

Selon ce complément facultatif, chaque premier ensemble de commutation 30 est de préférence en forme d'un premier pont de commutation respectif, et comporte alors au moins une première branche de commutation 32.

En complément facultatif encore, au moins un premier ensemble de commutation 30 comporte deux premières branches de commutation 32. Selon ce complément facultatif, chaque premier ensemble de commutation 30 comporte de préférence deux premières branches de commutation 32.

Dans les exemples des figures 1 à 3, 11 à 13 et 15, le ou chaque premier ensemble de commutation 30 comporte deux premières branches de commutation 32. Dans les exemples des figures 1 à 3, 11 à 13 et 15, le ou chaque premier ensemble de commutation 30 est de préférence constitué des deux premières branches de commutation 32.

Dans les exemples des figures 1 à 3, 12, 13 et 15, les deux premiers interrupteurs 36 sont notés $K_5$, $K_6$ pour l'une des deux premières branches de commutation 32, et respectivement $K_7$, $K_8$ pour l'autre des deux premières branches de commutation 32. Dans l'exemple de la figure 11, les deux premiers interrupteurs 36 sont notés $K_{5,k}$, $K_{6,k}$ pour l'une des deux premières branches de commutation 32, et respectivement $K_{7,k}$, $K_{8,k}$ pour l'autre des deux premières branches de commutation 32, où k est l'indice entier pour la tension d'entrée, compris entre 1 et E.

Dans les exemples des figures 4 à 10, le premier ensemble de commutation 30 comporte une seule première branche de commutation 32. Dans les exemples des figures 4 à 10, le premier ensemble de commutation 30 est de préférence constitué d'une unique première branche de commutation 32. Dans ces exemples, les deux premiers interrupteurs 36 sont notés $K_5$, $K_6$ pour l'unique première branche de commutation 32.

Parmi les deux bornes d'application 34 de la tension d'entrée $V_{in}$, l'une présente un potentiel inférieur, noté $V_{inn}$, et l'autre présente un potentiel supérieur, noté $V_{inp}$.

Lorsque le convertisseur d'énergie électrique 10 est configuré pour recevoir plusieurs tensions d'entrée distinctes $V_{in\_k}$, tel que dans l'exemple de la figure 11, il comprend, pour chaque tension d'entrée $V_{in\_k}$ respective, un premier ensemble de commutation 30 respectif. Dans cet exemple de la figure 11, les potentiels inférieurs des tensions d'entrée $V_{in\_1}$, $V_{in\_2}$ sont respectivement notés $V_{inn1}$, $V_{inn2}$, et les potentiels supérieurs des tensions d'entrée $V_{in\_1}$, $V_{in\_2}$ sont respectivement notés $V_{inp1}$, $V_{inp2}$.

Le convertisseur 10 comprend N deuxième(s) ensemble(s) de commutation 40, chacun étant associé à une tension de sortie respective $V_{out}$, $V_{out\_j}$ et comportant au moins deux deuxièmes interrupteurs 46, chaque deuxième interrupteur 46 étant connecté à une borne 44 de fourniture de la tension de sortie respective $V_{out}$, $V_{out\_j}$, où N est le nombre de tension(s) de sortie distincte(s) $V_{out}$, $V_{out\_j}$, N étant supérieur ou égal à 1.

Dans les exemples des figures 1 à 13 et 15, les deuxièmes interrupteurs 46 correspondent aux interrupteurs $K_1$, $K_2$, $K_3$, $K_4$ visibles au moins en partie sur les figures 1 à 9, 13 et 15, ou aux interrupteurs $K_{i,m}$ visibles sur les figures 10 à 12, avec i compris entre 1 et 4.

Dans les exemples des figures 1 à 9, 11, 13 et 15, où N est égal à 1, le convertisseur 10 comprend un seul deuxième ensemble de commutation 40 associé à la tension de sortie Veut.

Dans l'exemple de la figure 10, où N est égal à 3, le convertisseur 10 comprend trois deuxièmes ensembles de commutation 40, chacun étant associé à une tension de sortie respective $V_{out\_1}$, $V_{out\_2}$, $V_{out\_3}$ ; et dans l'exemple de la figure 12, où N est égal à 2, le convertisseur 10 comprend deux deuxièmes ensembles de commutation 40, chacun étant associé à une tension de sortie respective $V_{out\_1}$, $V_{out\_2}$.

En complément facultatif, au moins un deuxième ensemble de commutation 40 est en forme d'un deuxième pont de commutation comportant au moins une deuxième branche de commutation 42, chaque deuxième branche de commutation 42 étant connectée entre deux bornes 44 de fourniture d'une tension de sortie respective $V_{out}$, $V_{out\_j}$ et comportant au moins deux deuxièmes interrupteurs 46 connectés en série et reliés entre eux en un deuxième point milieu 48. Chaque deuxième branche de commutation 32 est de préférence constituée des deux deuxièmes interrupteurs 46.

Selon ce complément facultatif, chaque deuxième ensemble de commutation 40 est de préférence en forme d'un deuxième pont de commutation respectif, et comporte alors au moins une deuxième branche de commutation 42.

En complément facultatif encore, au moins un deuxième ensemble de commutation 40 comporte deux deuxièmes branches de commutation 42. Selon ce complément facultatif, chaque deuxième ensemble de commutation 40 comporte de préférence deux deuxièmes branches de commutation 42.

Dans les exemples des figures 1 à 6, 11 à 13 et 15, le ou chaque deuxième ensemble de commutation 40 comporte deux deuxièmes branches de commutation 42. Dans les exemples des figures 1 à 6, 11 à 13 et 15, le ou chaque deuxième ensemble de commutation 40 est de préférence constitué des deux deuxièmes branches de commutation 42.

Dans les exemples des figures 1 à 6, 11, 13 et 15, les deux deuxièmes interrupteurs 46 sont notés $K_1$, $K_2$ pour l'une des deux deuxièmes branches de commutation 42, et respectivement $K_3$, $K_4$ pour l'autre des deux deuxièmes branches de commutation 42. Dans l'exemple de la figure 12, les deux deuxièmes interrupteurs 46 sont notés $K_{1,j}$, $K_{2,j}$ pour l'une des deux deuxièmes branches de commutation 42, et respectivement $K_{3,j}$, $K_{4,j}$ pour l'autre des deux deuxièmes branches de commutation 42, où j est l'indice entier pour la tension de sortie, compris entre 1 et N.

Dans les exemples des figures 7 et 8, le deuxième ensemble de commutation 40 comporte une seule deuxième branche de commutation 42. Dans les exemples des figures 7 et 8, le deuxième ensemble de commutation 40 est de préférence constitué d'une unique deuxième branche de commutation 42. Dans l'exemple de la figure 8, les deux deuxièmes interrupteurs 46 sont notés $K_1$, $K_2$ pour l'unique deuxième branche de commutation 42. Dans l'exemple de la figure 7, les deux deuxièmes interrupteurs 46 sont notés $K_3$, $K_4$ pour l'unique deuxième branche de commutation 42.

Dans l'exemple de la figure 9, le deuxième ensemble de commutation 40 comporte deux deuxièmes interrupteurs 46 connectés à une même borne de fourniture de tension de sortie 44. Dans cet exemple, les deux deuxièmes interrupteurs 46 sont notés $K_1$, $K_3$.

Dans l'exemple de la figure 10, le convertisseur 10 comprend trois deuxièmes ensembles de commutation 40, parmi lesquels deux deuxièmes ensembles de commutation 40 comportent chacun deux deuxièmes interrupteurs 46 connectés à une même borne de fourniture de tension de sortie 44, ces deuxièmes interrupteurs 46 étant notés $K_{1,1}$, $K_{3,1}$, respectivement $K_{1,2}$, $K_{3,2}$. L'autre deuxième ensemble de commutation 40 comporte deux deuxièmes branches de commutation 42, les deux deuxièmes interrupteurs 46 étant alors notés $K_{1,3}$, $K_{2,3}$ pour l'une des deux deuxièmes branches de commutation 42, et respectivement $K_{3,3}$, $K_{4,3}$ pour l'autre des deux deuxièmes branches de commutation 42, cet autre deuxième ensemble de commutation 40 étant associé à la tension de sortie $V_{out\_3}$, d'indice j égal à 3.

Parmi les deux bornes de fourniture 44 de la tension de sortie $V_{out}$, l'une présente un potentiel inférieur, noté $V_{outn}$, et l'autre présente un potentiel supérieur, noté $V_{outp}$.

Lorsque le convertisseur d'énergie électrique 10 est configuré pour délivrer plusieurs tensions de sortie distinctes $V_{out\_j}$, tel que dans les exemples des figures 10 et 12, il comprend, pour chaque tension de sortie $V_{out\_j}$ respective, un deuxième ensemble de commutation 40 respectif. Dans ces exemples des figures 10 et 12, les potentiels inférieurs des tensions de sortie $V_{out\_1}$, $V_{out\_2}$, voire $V_{out\_3}$ (figure 10), sont respectivement notés $V_{outn1}$, $V_{outn2}$, $V_{outn3}$, et les potentiels supérieurs des tensions de sortie $V_{out\_1}$, $V_{out\_2}$, voire $V_{out\_3}$ sont respectivement notés $V_{outp1}$, $V_{outp2}$, $V_{outp3}$.

Selon l'invention, le convertisseur 10 comprend en outre un transformateur électrique 80 comportant au moins un enroulement primaire 82 et au moins un enroulement secondaire 84, chaque enroulement primaire 82 étant relié à un premier ensemble de commutation 30, chaque enroulement secondaire 84 étant relié à un deuxième ensemble de commutation 40.

De manière générale, la tension aux bornes de l'enroulement primaire 82, également appelée tension au primaire, est notée V1, la tension aux bornes de l'enroulement secondaire 84, également appelée tension au secondaire, est notée V2, et le rapport de transformation m du transformateur électrique 80 est égal au ratio de la tension au secondaire V2 divisée par la tension au primaire V1. Autrement dit, la tension au primaire V1 est égale à m fois la tension au secondaire V2, selon l'équation suivante :

[1]

$$V1 = m \cdot V2$$

où V2 représente la tension aux bornes de l'enroulement secondaire 84,

V1 représente la tension aux bornes de l'enroulement primaire 82, et

m représente le rapport de transformation du transformateur électrique 80.

Dans l'exemple de la figure 11, le transformateur électrique 80 comporte deux enroulements primaires 82, la tension aux bornes d'un enroulement primaire 82 étant alors notée V1,1, et celle aux bornes de l'autre enroulement primaire 82 étant notée V1,2.

Dans l'exemple de la figure 12, le transformateur électrique 80 comporte deux enroulements secondaires 84, la tension aux bornes d'un enroulement secondaire 84 étant alors notée V2,1, et celle aux bornes de l'autre enroulement secondaire 84 étant notée V2,2.

Le transformateur électrique 80 est par exemple un transformateur magnétique, et comporte alors en outre un noyau magnétique 86, chaque enroulement 82, 84 étant alors agencé autour du noyau magnétique 86.

En variante, le transformateur électrique 80 est un transformateur à air, et ne comporte alors pas de noyau magnétique. Cette variante est en particulier adaptée lorsque le convertisseur d'énergie électrique 10 fonctionne à haute fréquence, telle qu'une fréquence supérieure à 10 MHz.

Le transformateur électrique 80 est par exemple encore un autotransformateur, pour lequel une partie des spires est mutualisée entre deux enroulements, par exemple mutualisée entre l'enroulement primaire 82 et l'enroulement secondaire 84, ou mutualisée entre deux enroulements primaires 82, ou encore mutualisée entre deux enroulements secondaires 84.

Selon l'invention, chaque ensemble piézoélectrique 12 est connecté entre un interrupteur 36, 46 et un enroulement 82, 84 respectifs. Autrement dit, chaque ensemble piézoélectrique 12 est connecté entre un ensemble de commutation 30, 40 et un enroulement 82, 84 respectifs. Par convention, chaque ensemble piézoélectrique 12 est connecté par sa première extrémité 16 à un ensemble de commutation 30, 40 respectif, et par sa deuxième extrémité 18 à un enroulement 82, 84 respectif.

Chaque ensemble piézoélectrique 12 est connecté entre un premier interrupteur 36 et un enroulement primaire 82, ou bien est connecté entre un deuxième interrupteur 46 et un enroulement secondaire 84.

En complément facultatif, le convertisseur 10 comprend au moins un couple d'ensembles piézoélectriques 12 connectés à un même enroulement respectif 82, 84, comme représenté dans les exemples des figures 1, 2, 4, 13 et 15.

Dans les exemples des figures 1 et 4, le convertisseur 10 comprend deux couples d'ensembles piézoélectriques 12, un premier couple d'ensembles piézoélectriques 12 étant connecté à l'enroulement primaire 82 et un deuxième couple d'ensembles piézoélectriques 12 étant connecté à l'enroulement secondaire 84.

Dans les exemples des figures 2, 13 et 15, le convertisseur 10 comprend un seul couple d'ensembles piézoélectriques 12. Dans ces exemples, le couple d'ensembles piézoélectriques 12 est connecté à l'enroulement primaire 82.

Dans les autres exemples des figures 3 et 5 à 12, le convertisseur 10 comprend au plus un ensemble piézoélectrique 12 connecté à chaque enroulement 82, 84 respectif. Dans les exemples des figures 3, 6, 9 et 10, le convertisseur 10 comprend un seul ensemble piézoélectrique 12, connecté à l'enroulement primaire 82. Dans les exemples des figures 5, 7 et 8, le convertisseur 10 comprend deux ensembles piézoélectriques 12, l'un étant connecté à l'enroulement primaire 82 et l'autre étant connecté à l'enroulement secondaire 84. Dans l'exemple de la figure 11, le convertisseur 10 comprend deux ensembles piézoélectriques 12, l'un étant connecté à l'un des deux enroulements primaires 82 et l'autre étant connecté à l'enroulement secondaire 84. Dans l'exemple de la figure 12, le convertisseur 10 comprend deux ensembles piézoélectriques 12, chacun étant connecté à un enroulement secondaire 84 respectif.

Dans les exemples des figures 1 à 3, 5, 6, 8, 11 à 13 et 15, chaque ensemble piézoélectrique 12 est connecté entre, d'une part, un point milieu 38, 48 respectif, et d'autre part, un enroulement 82, 84 respectif. En particulier, dans les exemples des figures 1, 2, 13 et 15, les ensembles piézoélectriques 12 de chaque couple connecté à l'enroulement primaire 82 sont connectés chacun entre un premier point milieu 38 respectif et l'enroulement primaire 82. En outre, dans l'exemple de la figure 1, les ensembles piézoélectriques 12 du couple connecté à l'enroulement secondaire 84 sont connectés chacun entre un deuxième point milieu 48 respectif et l'enroulement secondaire 84. Dans les exemples des figures 3 et 6, l'unique ensemble piézoélectrique 12 est connecté entre un premier point milieu 38 respectif et l'enroulement primaire 82. Dans les exemples des figures 5, 8 et 11, un ensemble piézoélectrique 12 est connecté entre un premier point milieu 38 respectif et l'enroulement primaire 82, et l'autre ensemble piézoélectrique 12 est connecté entre un deuxième point milieu 48 respectif et l'enroulement secondaire 84. Dans l'exemple de la figure 12, chaque ensemble piézoélectrique 12 est connecté entre un deuxième point milieu 48 respectif et un enroulement secondaire 84 respectif.

Dans l'exemple de la figure 4, pour le couple d'ensembles piézoélectriques 12 connecté à l'enroulement primaire 82, un ensemble piézoélectrique 12 est connecté entre un point milieu 38 respectif et l'enroulement primaire 82, et l'autre ensemble piézoélectrique 12 est connecté entre une borne d'application de la tension d'entrée 34 et l'enroulement primaire 82 ; et pour le couple d'ensembles piézoélectriques 12 connecté à l'enroulement secondaire 84, chaque ensemble piézoélectrique 12 est connecté entre un deuxième point milieu 48 respectif et l'enroulement secondaire 84.

Dans l'exemple de la figure 7, un ensemble piézoélectrique 12 est connecté entre un point milieu 38 respectif et l'enroulement primaire 82, et l'autre ensemble piézoélectrique 12 est connecté entre une borne de fourniture de la tension de sortie 44 et l'enroulement secondaire 84.

Dans les exemples des figures 9 et 10, l'unique ensemble piézoélectrique 12 est connecté entre une borne d'application de la tension d'entrée 34 et l'enroulement primaire 82.

En complément, chaque enroulement 82, 84 est de préférence connecté à au moins un ensemble piézoélectrique 12 ou bien présente entre ses extrémités 88 (référencées sur les figures 9 et 10) une tension de valeur moyenne sensiblement nulle sur un cycle respectif de résonance, le dispositif de pilotage 20 étant alors configuré pour commander les interrupteurs 36 ou 46 de l'ensemble de commutation 30 ou 40 connecté audit enroulement 82, 84 de manière à obtenir ladite tension de valeur moyenne sensiblement nulle.

Selon ce complément, lorsque le convertisseur 10 comprend plusieurs ensembles piézoélectriques 12, chaque enroulement 82, 84 est de préférence connecté à au moins un ensemble piézoélectrique 12. Autrement dit, selon ce complément et lorsque le convertisseur 10 comprend plusieurs ensembles piézoélectriques 12, au moins un ensemble piézoélectrique 12 est connecté à l'enroulement primaire 82, et au moins un autre ensemble piézoélectrique 12 est connecté à l'enroulement secondaire 84.

Selon ce complément, lorsque le convertisseur 10 comprend un seul ensemble piézoélectrique 12 connecté à un enroulement respectif 82 ; 84, et le ou chaque autre enroulement 84 ; 82 présente entre ses extrémités 88 une tension de valeur moyenne sensiblement nulle sur un cycle respectif de résonance.

Chaque ensemble piézoélectrique 12 comporte au moins un élément piézoélectrique 15.

De préférence, chaque ensemble piézoélectrique 12 est constitué selon l'une des constitutions parmi le groupe consistant en : un unique élément piézoélectrique 15 ; plusieurs éléments piézoélectriques 15 connectés en série ; plusieurs éléments piézoélectriques 15 connectés en parallèle ; un élément piézoélectrique 15 et un condensateur auxiliaire, non représenté, connectés en série ; un élément piézoélectrique 15 et un condensateur auxiliaire connectés en parallèle ; et un agencement de plusieurs branches parallèles, chaque branche comportant un ou plusieurs éléments piézoélectriques 15 connectés en série ou un condensateur auxiliaire.

Le condensateur auxiliaire est typiquement de capacité supérieure, de préférence au moins trois fois supérieure, à une capacité de référence $C_0$, décrite ci-après, du ou des éléments piézoélectriques 15.

En complément facultatif, le ou chaque couple d'ensembles piézoélectriques 12 partagent un même matériau piézoélectrique, tout en ayant les électrodes d'un ensemble piézoélectrique 12 respectif distinctes de celles de l'autre ensemble piézoélectrique 12 dudit couple. Selon ce complément facultatif, les paires d'électrodes d'un ensemble piézoélectrique 12 respectif, et respectivement celles de l'autre ensemble piézoélectrique 12 dudit couple, couvrent des surfaces de matériau distinctes. En outre, les électrodes d'un ensemble piézoélectrique 12 respectif ne peuvent dans ce cas pas directement induire un champ électrique significatif dans la partie du matériau piézoélectrique appartenant à l'autre ensemble piézoélectrique 12 dudit couple. Selon ce complément facultatif encore, la capacité entre l'une quelconque des électrodes d'un ensemble piézoélectrique 12 respectif et l'une quelconque des électrodes de l'autre ensemble piézoélectrique 12 dudit couple est négligeable (au moins 10 fois inférieure) devant une capacité de référence $C_0$, décrite ci-après, de chacun des ensembles 12, par exemple en n'étant pas directement en regard de part et d'autre du matériau. Cette mise en commun d'un même matériau permet par exemple de faciliter l'implémentation du couple d'ensembles piézoélectriques 12 (limitation du nombre de pièce(s), mise en commun des moyens de fixation) ; et aussi de synchroniser la vibration des deux ensembles piézoélectriques 12, sans toutefois qu'il y ait un transfert significatif d'énergie d'un ensemble 12 à l'autre (<1/10ème de la puissance de sortie).

L'élément piézoélectrique 15 est connu en soi, et est typiquement modélisé, proche du mode de résonance exploité, sous la forme d'un condensateur 52 et d'une branche résonante 54 connectée en parallèle du condensateur 52, le condensateur 52 et la branche résonante 54 étant connectés entre une première électrode 56 et une deuxième électrode 58 de l'élément piézoélectrique 15, comme illustré sur la modélisation de l'élément piézoélectrique 15 représentée dans une bulle 60 à la figure 1. La branche résonante 54 est typiquement une branche RLC formée d'un condensateur 62, d'une résistance 64 et d'une inductance 66 connectés en série. La capacité du condensateur 52 connecté en parallèle de la branche résonante 54 est appelée capacité parallèle, ou capacité bloquée, ou encore capacité de référence, et notée $C_0$. La tension aux bornes de l'élément piézoélectrique 15 correspond alors typiquement à la tension aux bornes du condensateur 52.

Dans la présente description, une tension dite piézoélectrique totale $V_p$ est par convention la somme de chacune des tensions aux bornes des ensembles piézoélectriques 12 ramenés au primaire du transformateur électrique 80.

Par convention, dans la présente description, la tension piézoélectrique totale $V_p$ représente la tension totale, vu du côté primaire du transformateur électrique 80, du ou des ensembles piézoélectriques 12 qui agissent en série. Ainsi, les tensions aux bornes des ensembles piézoélectriques 12 qui sont connectés à l'enroulement secondaire 84 sont multipliées par le rapport de transformation m du transformateur électrique 80, lorsque ramenées au primaire.

Dans les exemples des figures 1 et 4, la tension piézoélectrique totale $V_p$ vérifie alors l'équation suivante :

[2]

$$V_p = V_{p1} + V_{p3} + m \cdot V_{p2} + m \cdot V_{p4}$$

où $V_{p1}$, $V_{p3}$ représentent les tensions respectives aux bornes de chacun des ensembles piézoélectriques 12 connectés à l'enroulement primaire 82, et

$V_{p2}$, $V_{p4}$ représentent les tensions respectives aux bornes de chacun des ensembles piézoélectriques 12 connectés à l'enroulement secondaire 84.

De manière analogue, dans les exemples des figures 2, 13 et 15, la tension piézoélectrique totale $V_p$ vérifie alors l'équation suivante :

[3]

$$V_p = V_{p1} + V_{p3}$$

où $V_{p1}$, $V_{p3}$ représentent les tensions respectives aux bornes de chacun des ensembles piézoélectriques 12 connectés à l'enroulement primaire 82.

Dans les exemples des figures 3, 6, 9 et 10, la tension piézoélectrique totale $V_p$ est égale à la tension aux bornes de l'unique ensemble piézoélectrique 12.

Dans les exemples des figures 5, 7 et 8, la tension piézoélectrique totale $V_p$ vérifie alors l'équation suivante :

[4]

$$V_p = V_{p1} + m \cdot V_{p2}$$

où $V_{p1}$ représente la tension aux bornes de l'ensemble piézoélectrique 12 connecté à l'enroulement primaire 82, et

$V_{p2}$ représente la tension aux bornes de l'ensemble piézoélectrique 12 connecté à l'enroulement secondaire 84.

Dans l'exemple de la figure 12, à deux tensions de sortie $V_{out\_1}$, $V_{out\_2}$ distinctes, chacune associée à un enroulement secondaire 84 respectif, et un ensemble piézoélectrique 12 connecté à chaque enroulement secondaire 84, il y a deux tensions piézoélectriques distinctes, pilotées indépendamment l'une de l'autre par le dispositif électronique de pilotage 20, à savoir une première tension piézoélectrique $V_{p\_out1}$ et une deuxième tension piézoélectrique $V_{p\_out2}$.

Dans cet exemple de la figure 12, la première tension piézoélectrique $V_{p\_out1}$ vérifie l'équation suivante :

[5]

$$V_{p\_out1} = m1 \cdot V_{2,1}$$

où $V_{p\_out1}$ représente la première tension piézoélectrique, c'est-à-dire la tension piézoélectrique ramenée au primaire pour l'ensemble piézoélectrique 12 connecté à l'enroulement secondaire 84 associé à la première tension de sortie $V_{out\_1}$,

$V_{2,1}$ représente la tension aux bornes dudit ensemble piézoélectrique 12 connecté à l'enroulement secondaire 84 associé à la première tension de sortie $V_{out\_1}$, et

m1 est le rapport de transformation entre l'enroulement primaire 82 et l'enroulement secondaire 84 associé à la première tension de sortie $V_{out\_1}$, vérifiant l'équation :

[6]

$$V1 = m1 \cdot V_{2,1}$$

où $V_{2,1}$ représente la tension aux bornes dudit enroulement secondaire 84 associé à la première tension de sortie $V_{out\_1}$,

V1 représente la tension aux bornes de l'enroulement primaire 82, et

m1 représente ledit rapport de transformation.

Dans cet exemple de la figure 12, la deuxième tension piézoélectrique $V_{p\_out2}$ vérifie l'équation suivante :

[7]

$$V_{p\_out2} = m2 \cdot V_{p2,2}$$

où $V_{p\_out2}$ représente la deuxième tension piézoélectrique, c'est-à-dire la tension piézoélectrique ramenée au primaire pour l'ensemble piézoélectrique 12 connecté à l'enroulement secondaire 84 associé à la deuxième tension de sortie $V_{out\_2}$,
$V_{p2,2}$ représente la tension aux bornes dudit ensemble piézoélectrique 12 connecté à l'enroulement secondaire 84 associé à la deuxième tension de sortie $V_{out\_2}$, et
m2 est le rapport de transformation entre l'enroulement primaire 82 et l'enroulement secondaire 84 associé à la deuxième tension de sortie $V_{out\_2}$, vérifiant l'équation :

[8]

$$V1 = m2 \cdot V2,2$$

où V2,2 représente la tension aux bornes dudit enroulement secondaire 84 associé à la deuxième tension de sortie $V_{out\_2}$,
V1 représente la tension aux bornes de l'enroulement primaire 82, et
m2 représente ledit rapport de transformation.

La première tension piézoélectrique $V_{p\_out1}$ permet ainsi de gérer le courant échangé avec la première tension de sortie $V_{out\_1}$, et la deuxième tension piézoélectrique $V_{p\_out2}$ permet de gérer le courant échangé avec la deuxième tension de sortie $V_{out\_2}$, et ce de manière indépendante entre la première tension de sortie $V_{out\_1}$ et la deuxième tension de sortie $V_{out\_2}$, de même qu'entre les courants respectifs associés à ces tensions de sortie $V_{out\_1}$, $V_{out\_2}$ distinctes.
De même, dans l'exemple de la figure 11, à deux tensions d'entrée $V_{in\_1}$, $V_{in\_2}$ distinctes, chacune associée à un enroulement primaire 82 respectif, il y a aussi deux tensions piézoélectriques distinctes, pilotées indépendamment l'une de l'autre par le dispositif électronique de pilotage 20, à savoir une première tension piézoélectrique $V_{p\_out1}$ et une deuxième tension piézoélectrique $V_{p\_in2}$.
Dans cet exemple de la figure 11, la première tension piézoélectrique $V_{p\_out1}$ vérifie l'équation suivante :

[9]

$$V_{p\_out1} = m1' \cdot V_{p2}$$

où $V_{p\_out1}$ représente la première tension piézoélectrique dans cet exemple, c'est-à-dire la tension piézoélectrique ramenée au primaire de la première tension d'entrée $V_{in\_1}$, pour l'ensemble piézoélectrique 12 connecté à l'enroulement secondaire 84,
$V_{p2}$ représente la tension aux bornes dudit ensemble piézoélectrique 12 connecté à l'enroulement secondaire 84, et
m1' est le rapport de transformation entre l'enroulement primaire 82 associé à la première tension d'entrée $V_{in\_1}$ et l'enroulement secondaire 84, vérifiant l'équation suivante :

[10]

$$V1,1 = m1' \cdot V2$$

où V2 représente la tension aux bornes de l'enroulement secondaire 84,
V1,1 représente la tension aux bornes dudit enroulement primaire 82 associé à la première tension d'entrée $V_{in\_1}$, et
m1' représente ledit rapport de transformation.

Dans cet exemple de la figure 11, le rapport de transformation entre l'enroulement primaire 82 associé à la deuxième tension d'entrée $V_{in\_2}$ et l'enroulement secondaire 84 est noté m2' et vérifie l'équation :

[11]

$$V1,2 = m2' \cdot V2$$

où V2 représente la tension aux bornes de l'enroulement secondaire 84,
V1,2 représente la tension aux bornes dudit enroulement primaire 82 associé à la deuxième tension d'entrée $V_{in\_2}$, et
m2' représente ledit rapport de transformation.

Dans cet exemple de la figure 11, la deuxième tension piézoélectrique $V_{p\_in2}$ vérifie l'équation suivante :

[12]

$$V_{p\_in2} = V_{p1}$$

où $V_{p\_in2}$ représente la deuxième tension piézoélectrique dans cet exemple de la figure 11, c'est-à-dire la tension piézoélectrique au primaire pour l'ensemble piézoélectrique 12 connecté à l'enroulement primaire 82 associé à la deuxième tension d'entrée $V_{in\_2}$, et
$V_{p1}$ représente la tension aux bornes dudit ensemble piézoélectrique 12 connecté à l'enroulement primaire 82 associé à la deuxième tension d'entrée $V_{in\_2}$.

L'homme du métier comprendra alors que dans l'exemple de la figure 11, le principe de pilotage est le même que dans l'exemple de la figure 12, sauf qu'au lieu de piloter la deuxième sortie pour fournir une seconde tension de sortie $V_{out\_2}$, le pilotage est modifié pour que le courant s'inverse et que la deuxième sortie devienne une entrée. Cette entrée est pilotée en relatif à la première entrée. C'est alors comme si la deuxième tension d'entrée $V_{in\_2}$ fournissait de la puissance à la première tension d'entrée $V_{in\_1}$ qui elle-même envoie de la puissance à la tension de sortie $V_{out}$. Ceci permet alors un pilotage indépendant de la tension de sortie $V_{out}$ d'une part, et du courant tiré sur la deuxième tension d'entrée $V_{in\_2}$ d'autre part.
En variante de l'exemple de la figure 11, au lieu de connecter un ensemble piézoélectrique 12 à l'enroulement secondaire 84, un ensemble piézoélectrique 12 est connecté à l'enroulement primaire 82 associé à la première tension d'entrée $V_{in\_1}$. Selon cette variante, les deux tensions d'entrée $V_{in\_1}$, $V_{in\_2}$ sont alors pilotées vis-à-vis de la tension de sortie $V_{out}$.
L'homme du métier comprendra qu'en pratique, sur un enroulement 82, 84 où il n'y a pas d'ensemble piézoélectrique 12 connecté, on ne peut pas faire de pilotage pour différencier un courant qui irait plutôt à une sortie qu'à une autre. C'est donc sur les enroulements 82, 84 auxquels un ensemble piézoélectrique 12 respectif est connecté qu'il est possible de maitriser le courant échangé ; et le ou chaque enroulement 82, 84 sans ensemble piézoélectrique 12 subit le pilotage, et compense le bilan total des puissances échangées, la somme des puissances de sortie étant égale à la somme des puissances d'entrée aux pertes près.
En outre, dans la présente description et comme représenté sur les figures 1 à 9, 13 et 15, la tension entre les premiers points milieux 38 est notée $V_{pa}$, et est égale à la différence de potentiels ($V_{pa1}$ - $V_{pa2}$), où $V_{pa1}$ est le potentiel de l'un des deux premiers points milieux 38, et $V_{pa2}$ est le potentiel de l'autre premier point milieu 38. Par convention, lorsque le premier ensemble de commutation 30 comporte une seule première branche de commutation 32, le potentiel parmi $V_{pa1}$, $V_{pa2}$ qui n'est pas associé au premier point milieu 38 de cette première branche de commutation 32 correspond alors au potentiel $V_{inn}$, $V_{inp}$ de l'une des deux bornes d'application de tension d'entrée 34 ou bien à celui d'une extrémité 88 respective de l'enroulement primaire 82. Dans les exemples des figures 4 à 10, le potentiel $V_{pa2}$ est égal au potentiel inférieur $V_{inn}$ de la tension d'entrée.
Lorsque le convertisseur d'énergie électrique 10 est configuré pour recevoir plusieurs tensions d'entrée distinctes $V_{in\_k}$, tel que dans l'exemple de la figure 11, la tension entre les premiers points milieux 38 est notée $V_{pa\_k}$ pour chaque premier ensemble de commutation 30 associé à la tension d'entrée $V_{in\_k}$ respective, et est égale à la différence de potentiels ($V_{pa1,k}$ - $V_{pa2,k}$), où $V_{pa1,k}$ est le potentiel de l'un des deux premiers points milieux 38, et $V_{pa2,k}$ est le potentiel de l'autre premier point milieu 38 dudit premier ensemble de commutation 30, avec la convention précitée restant applicable.
La tension entre les deuxièmes points milieux 48 est notée $V_{pb}$, et est égale à la différence de potentiels ($V_{pb2}$ - $V_{pb1}$), où $V_{pb1}$ est le potentiel de l'un des deux deuxièmes points milieux 48, et $V_{pb2}$ est le potentiel de l'autre deuxième point milieu 48. Par convention également, lorsque le deuxième ensemble de commutation 40 comporte une seule deuxième branche de commutation 42, le potentiel parmi $V_{pb1}$, $V_{pb2}$ qui n'est pas associé au deuxième point milieu 48 de cette deuxième branche de commutation 42 correspond alors au potentiel $V_{outn}$, $V_{outp}$ de l'une des deux bornes de fourniture de tension de sortie 44 ou bien à celui d'une extrémité 88 respective de l'enroulement secondaire 84. Dans l'exemple de la figure 7, le potentiel $V_{pb1}$ est égal au potentiel inférieur $V_{outn}$ de la tension de sortie ; et dans celui de la figure 8, le potentiel $V_{pb2}$ est égal audit potentiel inférieur $V_{outn}$ de la tension de sortie. Dans l'exemple de la figure 9, chaque potentiel $V_{pb1}$, $V_{pb2}$ est égal au potentiel d'une extrémité 88 respective de l'enroulement secondaire 84.

Lorsque le convertisseur d'énergie électrique 10 est configuré pour délivrer plusieurs tensions de sortie distinctes $V_{out\_j}$, tel que dans les exemples des figures 10 et 12, la tension entre les deuxièmes points milieux 48 est notée $V_{pb\_j}$ pour chaque deuxième ensemble de commutation 40 associé à la tension de sortie $V_{out\_j}$ respective, et est égale à la différence de potentiels $(V_{pb2,j} - V_{pb1,j})$, où $V_{pb1,j}$ est le potentiel de l'un des deux deuxièmes points milieux 48, et $V_{pb2,j}$ est le potentiel de l'autre deuxième point milieu 48 dudit deuxième ensemble de commutation 40, avec la convention précitée restant applicable.

La fréquence de résonance est la fréquence à laquelle oscille l'élément piézoélectrique 15 et par conséquent son courant $I_L$, représenté à la figure 1. Le cycle de conversion est synchronisé sur un mouvement mécanique de l'élément piézoélectrique 15, et la fréquence du pilotage est alors calée sur la fréquence d'oscillation mécanique. En pratique, cette fréquence d'oscillation dépend du point de fonctionnement du convertisseur 10 : valeurs des trois paliers de tension et du courant de sortie. En fonction du point de fonctionnement, cette fréquence d'oscillation évolue typiquement entre la fréquence de résonance dite série de l'élément piézoélectrique 15 $\omega_s = 1/\sqrt{(L_r.C_r)}$ où $L_r$ et $C_r$ correspondent aux inductance et capacité de la branche résonante 54) et la fréquence de résonance dite parallèle de l'élément piézoélectrique 15 $(\omega_p = 1/\sqrt{(L_r.C_r.C_0/(C_r+C_0))})$, également respectivement appelés fréquence de résonance et fréquence d'antirésonance de l'élément piézoélectrique 15. La fréquence de fonctionnement du convertisseur 10 est alors comprise entre ces deux fréquences de résonance et d'antirésonance de l'élément piézoélectrique 15. Le point de fonctionnement varie lentement au regard de la fréquence d'oscillation de l'élément piézoélectrique 15. Le point de fonctionnement évolue typiquement à moins de 10kHz, alors que la fréquence d'oscillation de l'élément piézoélectrique 15 est typiquement supérieure ou égale à 100kHz. De ce fait, la fréquence de fonctionnement du convertisseur 10 évolue peu d'une période à la suivante.

En complément facultatif, lorsque le convertisseur 10 comprend plusieurs ensembles piézoélectriques 12 connectés à l'enroulement primaire 82, lesdits ensembles piézoélectriques 12 au primaire, et les éléments piézoélectriques 15 les constituant, sont de préférence sensiblement identiques entre eux.

En complément facultatif et de manière analogue, lorsque le convertisseur 10 comprend plusieurs ensembles piézoélectriques 12 connectés à l'enroulement secondaire 84, lesdits ensembles piézoélectriques 12 au secondaire, et les éléments piézoélectriques 15 les constituant, sont de préférence sensiblement identiques entre eux.

Par ensembles piézoélectriques 12 sensiblement identiques entre eux, on entend qu'ils ont une même capacité de référence $C_0$ à 10% près et une même fréquence de résonance à 10% près.

En complément facultatif encore, le ou les ensembles piézoélectriques 12 connectés à l'enroulement secondaire 84 présentent une capacité de référence $C_0$ sensiblement égale à m fois la capacité de référence $C_0$ du ou des ensembles piézoélectriques 12 connectés à l'enroulement primaire 82, ceci à 50 % près.

D'une manière générale, pour le convertisseur d'énergie électrique 10 avec les ensembles piézoélectriques 12 et piloté par le dispositif électronique de pilotage 20, le nombre de phases à tension sensiblement constante est typiquement d'au moins 2, de préférence égal à 3, tout en pouvant être supérieur ou égal à 4 avec la mise en oeuvre du pilotage décrit dans la demande FR 21 07345 déposée le 7 juillet 2021.

Chaque phase à tension sensiblement constante est susceptible d'être obtenue à partir d'une combinaison des tensions d'entrée et de sortie, en valeur positive ou négative, tout en prenant en compte le rapport de transformation m du transformateur électrique 80, comme expliqué par la suite, notamment en regard du tableau 1. Le convertisseur d'énergie 10 permet alors d'échanger de l'énergie durant les phases à tension sensiblement constante, et par voie de conséquence, avec les combinaisons de tensions utilisées pour obtenir ces phases à tension sensiblement constante. Il est notamment possible de transférer de l'énergie d'une phase à tension sensiblement constante de faible tension vers une phase à tension sensiblement constante de tension plus élevée, et par le jeu des combinaisons précitées obtenir au final un convertisseur abaisseur de tension, ce qui peut paraître contre-intuitif. Inversement, il est également possible de transférer de l'énergie d'une phase à tension sensiblement constante de tension élevée vers une phase à tension sensiblement constante de tension plus faible, et par le jeu des combinaisons précitées obtenir au final un convertisseur élévateur de tension. L'homme du métier comprendra alors qu'il est possible d'avoir un cycle élévateur vu par les ensembles piézoélectriques 12 alors que le convertisseur d'énergie électrique 10 est un convertisseur abaisseur, et inversement d'avoir un cycle abaisseur vu par les ensembles piézoélectriques 12 alors que le convertisseur d'énergie électrique 10 est un convertisseur élévateur.

Par convention, si un courant est fourni aux ensembles piézoélectriques 12 lors de la phase à tension sensiblement constante correspondant à la tension la plus élevée au cours d'un cycle de résonance, alors le cycle est considéré comme un cycle abaisseur pour les ensembles piézoélectriques 12. Inversement, si un courant est débité, ou encore tiré, depuis les ensembles piézoélectriques 12 lors de ladite phase à tension sensiblement constante pour laquelle la tension est la plus élevée au cours du cycle de résonance, alors le cycle est considéré comme un cycle élévateur pour les ensembles piézoélectriques 12. Comme indiqué précédemment, le cycle de conversion vu par les ensembles piézoélectriques 12 est susceptible d'être un cycle élévateur alors que le convertisseur d'énergie électrique 10 fonctionne en convertisseur abaisseur, et inversement le cycle de conversion vu par les ensembles piézoélectriques 12 est susceptible d'être un cycle abaisseur alors que le convertisseur d'énergie électrique 10 fonctionne en convertisseur élévateur.

Le dispositif électronique de pilotage 20 est configuré pour piloter le convertisseur d'énergie électrique 10, en particulier pour piloter la commande des interrupteurs 36, 46 du convertisseur, afin d'alterner, lors d'un cycle respectif de résonance des ensembles piézoélectriques 12, des phases à tension sensiblement constante aux bornes des ensembles piézoélectriques 12 et des phases à charge sensiblement constante, c'est-à-dire en circuit sensiblement ouvert, aux bornes desdits ensembles piézoélectriques 12.

Le dispositif électronique de pilotage 20 est par exemple réalisé sous forme d'un circuit électronique comportant un ou plusieurs composants électroniques.

En variante, le dispositif électronique de pilotage 20 est réalisé sous forme d'un composant logique programmable, tel qu'un FPGA (de l'anglais *Field Programmable Gate Array),* ou sous forme d'un circuit intégré, tel qu'un ASIC (de l'anglais *Application Specific Integrated Circuit)* ou encore sous forme d'un calculateur, tel qu'un microcontrôleur, un processeur.

En complément facultatif, lorsque le convertisseur 10 comprend plusieurs ensembles piézoélectriques 12, le dispositif électronique de pilotage 20 est configuré en outre pour piloter la commande des interrupteurs 36, 46 du convertisseur, afin de faire fonctionner tous les ensembles piézoélectriques 12 sensiblement à la même fréquence de résonance, tel qu'à la même fréquence de résonance à 10% près.

Chacun des premiers 36 et deuxièmes 46 interrupteurs est de préférence un interrupteur unidirectionnel en courant et unidirectionnel en tension. L'interrupteur 36, 46 comprend par exemple un transistor, ou une diode, ou encore un transistor et une diode en antiparallèle, non représentés. L'interrupteur 36, 46 est de préférence constitué du transistor, ou de la diode, ou encore du transistor et de la diode en antiparallèle. En variante, l'interrupteur 36, 46 comprend une association de plusieurs transistors, et est de préférence constitué d'une telle association de plusieurs transistors. En variante encore, l'interrupteur 36, 46 comprend un switch mécanique, tel qu'un micro-switch MEMS (de l'anglais *MicroElectroMechanical System).*

Le transistor est, par exemple, un transistor à effet de champ à grille isolée, également appelé MOSFET (de l'anglais *Metal Oxide Semiconductor Field Effect Transistor).* En variante, le transistor est un transistor bipolaire ; un transistor bipolaire à grille isolée, également appelé IGBT (de l'anglais *Insulated Gate Bipolar Transistor)* ; un transistor à base de silicium (Si), un transistor à base de GaN (de l'anglais *Gallium Nitride)* ; un transistor à base de carbure de silicium (SiC), ou un transistor à base de diamant, ou encore un thyristor.

En complément facultatif, un enroulement 82, 84 comporte, entre ses extrémités 88, au moins un point intermédiaire 90 connecté à un ensemble de commutation respectif 30, 40 ou bien à une borne respective d'application de tension d'entrée 34 ou de fourniture de tension de sortie 44.

Selon ce complément facultatif, dans l'exemple de la figure 9, l'enroulement secondaire 84 comporte, entre ses extrémités 88, un point intermédiaire 90 connecté à une borne respective de fourniture de tension de sortie 44, à savoir celle présentant le potentiel supérieur $V_{outp}$ de tension de sortie. Dans l'exemple de la figure 10, l'enroulement secondaire 84 comporte, entre ses extrémités 88, plusieurs points intermédiaires 90. Certains points intermédiaires 90 sont connectés à un deuxième ensemble de commutation respectif 40 respectif, à savoir celui associé à la tension de sortie $V_{out\_2}$. Un autre point intermédiaire 90 est connecté à plusieurs bornes respectives de fourniture de tension de sortie 44, à savoir celles de potentiels supérieurs $V_{outp1}$, $V_{outp2}$ de tension de sortie.

Selon ce complément facultatif, en variante non représentée, l'enroulement primaire 82 comporte, entre ses extrémités 88, un point intermédiaire 90 connecté à un premier ensemble de commutation respectif 30, ou bien à une borne respective d'application de tension d'entrée 34.

Avec le convertisseur 10 selon l'invention, l'homme du métier observera que du fait de la présence d'au moins un ensemble piézoélectrique 12, connecté à l'enroulement primaire 82, ou respectivement à l'enroulement secondaire 84, le ou chaque ensemble piézoélectrique 12 permet en outre de réduire, voire de supprimer, une composante continue via son comportement capacitif à basse fréquence, i.e. pour une fréquence inférieure au dixième de celle d'un premier mode résonance. Ainsi, si la tension $V_{pa}$ et/ou la tension $V_{pb}$ présentent une composante continue, elle sera réduite, voire supprimée, par l'ensemble piézoélectrique 12, connecté à l'enroulement primaire 82, ou respectivement à l'enroulement secondaire 84. Les tensions au primaire V1 et au secondaire V2 sont alors à composante continue sensiblement nulle, ce qui permet un meilleur fonctionnement du transformateur électrique 80 sans risque de dérive en courant.

En outre, même si le transformateur électrique 80 offre un premier niveau d'isolation, le ou les ensembles piézoélectriques 12 rajoutent un niveau d'isolation complémentaire, par exemple pour atteindre un niveau d'isolation renforcé qui garantit par exemple l'isolation même en cas d'apparition d'un premier défaut.

Le fonctionnement du convertisseur 10 selon l'invention est alors analogue à celui de chacun des convertisseurs d'énergie électrique décrits dans les demandes FR 21 12925, FR 21 12926 et FR 21 12933 déposées le 3 décembre 2021, à la différence des valeurs de tension lors des phases à tension sensiblement constante aux bornes des ensembles piézoélectriques 12, également appelées valeurs de palier de tension, ces valeurs de palier de tension étant, du fait du rapport de transformation m du transformateur électrique 80, susceptibles de différer de celles décrites dans les demandes précitées.

Dans l'exemple des figures 1 à 9, 13 et 15, à la composante continue près et de par la topologie du convertisseur 10, le dispositif électronique de pilotage 20 est alors configuré pour, lors des phases à tension sensiblement constante aux bornes des ensembles piézoélectriques 12, piloter la commande des interrupteurs 36, 46 du convertisseur 10, afin d'avoir la valeur de la tension de chacune des phases à tension sensiblement constante, choisie parmi le groupe de valeurs définies dans le tableau 1 ci-après pour chacune des figures :

[Table 1]

| Figure | Valeurs possibles pour chaque palier de tension, avec le convertisseur de la figure respective |
|---|---|
| Figure 1 | $0$ ; $-V_{in}$ ; $+V_{in}$ ; $-mV_{out}$ ; $+mV_{out}$ ; $-V_{in}-mV_{out}$ ; $-V_{in}+mV_{out}$ ; $V_{in}-mV_{out}$ ; $V_{in}+mV_{out}$ |
| Figure 2 | $0$ ; $-V_{in}$; $+V_{in}$ ; $-mV_{out}$ ; $+mV_{out}$ ; $-V_{in}-mV_{out}$ ; $-V_{in}+MV_{out}$ ; $V_{in}-mV_{out}$ ; $V_{in}+mV_{out}$ |
| Figure 3 | $0$ ; $-V_{in}$; $+V_{in}$ ; $-mV_{out}$ ; $+mV_{out}$ ; $-V_{in}-mV_{out}$ ; $-V_{in}+mV_{out}$ ; $V_{in}-mV_{out}$ ; $V_{in}+mV_{out}$ |
| Figure 4 | $0$ ; $+V_{in}$ ; $-mV_{out}$ ; $+mV_{out}$ ; $V_{in}-mV_{out}$ ; $V_{in}+mV_{out}$ |
| Figure 5 | $0$ ; $+V_{in}$ ; $-mV_{out}$ ; $+mV_{out}$ ; $V_{in}-mV_{out}$ ; $V_{in}+mV_{out}$ |
| Figure 6 | $0$ ; $+V_{in}$ ; $-mV_{out}$ ; $+mV_{out}$ ; $V_{in}-mV_{out}$ ; $V_{in}+mV_{out}$ |
| Figure 7 | $0$ ; $+V_{in}$ ; $+mV_{out}$ ; $V_{in}+mV_{out}$ |
| Figure 8 | $0$ ; $+V_{in}$ ; $-mV_{out}$ ; $V_{in}-mV_{out}$ |
| Figure 9 | $0$ ; $+V_{in}$ ; $-mV_{out}$ ; $+mV_{out}$ ; $V_{in}-mV_{out}$ ; $V_{in}+mV_{out}$ |
| Figure 13 | $0$ ; $-V_{in}$; $+V_{in}$ ; $-mV_{out}$ ; $+mV_{out}$ ; $-V_{in}-mV_{out}$ ; $-V_{in}+mV_{out}$ ; $V_{in}-mV_{out}$ ; $V_{in}+mV_{out}$ |
| Figure 15 | $0$ ; $-V_{in}$; $+V_{in}$ ; $-mV_{out}$ ; $+mV_{out}$ ; $-V_{in}-mV_{out}$ ; $-V_{in}+mV_{out}$ ; $V_{in}-mV_{out}$ ; $V_{in}+mV_{out}$ |

où $V_{in}$ représente la tension d'entrée, $V_{out}$ représente la tension de sortie et m représente le rapport de transformation du transformateur électrique 80, et compte tenu des équations (2) à (4) précédentes.

Dans les exemples des figures 7 et 8, l'homme du métier observera que, de par la topologie du convertisseur 10, la tension $V_{pa}$ ne peut pas être négative et comporte alors nécessairement une composante continue, et de même pour la tension $V_{pb}$. Comme les tensions au primaire V1 et au secondaire V2 sont par principe sans composante continue, la composante continue de la tension $V_{p4}$ est alors supprimée par l'ensemble piézoélectrique 12 disposé entre cette tension $V_{pa}$ et l'enroulement primaire 82, pour former la tension au primaire V1. Une composante continue est ensuite réintroduite en la tension $V_{pb}$ par rapport à la tension au secondaire V2, via l'ensemble piézoélectrique 12 disposé entre l'enroulement primaire 84 et cette tension $V_{pb}$. Par rapport à un cycle d'un convertisseur de l'état de la technique sans transformateur électrique, il est alors possible d'avoir une modification de la composante continue de la tension piézoélectrique totale $V_p$. Toutefois, en régime permanent, il y a un équilibre des charges échangées sur chacun des ensembles piézoélectriques 12 sur une période d'oscillation mécanique, et la présence éventuelle d'une composante de tension continue sur les ensembles piézoélectriques 12 ne modifie donc pas l'équilibre d'énergie échangée sur une période d'oscillation mécanique ($\int I_L.V_{pi-moy}dt=0$). L'homme du métier comprendra alors la précision « à la composante continue près » indiquée ci-dessus, pour la présentation des valeurs possibles des paliers de tension. En effet, il est possible qu'une composante continue s'ajoute lors des phases à tension sensiblement constante et sur chacun des ensembles piézoélectriques 12, sans que cela modifie le comportement du convertisseur 10 selon l'invention, en termes de puissance de sortie, d'amplitude du courant $I_L$ circulant dans les éléments piézoélectriques 15, ou encore de régulation.

Dans l'exemple de la figure 9, les interrupteurs $K_7$ et $K_8$ ont été retirés au primaire par rapport à une topologie à deux premières branches de commutation 32, et l'homme du métier observera qu'en variante, les interrupteurs $K_5$ et $K_6$ auraient pu être retirés, en reliant alors un point intermédiaire 90 de l'enroulement primaire 82 au potentiel inférieur $V_{inn}$ ou supérieur $V_{inp}$ de tension d'entrée.

De même, les interrupteurs $K_2$ et $K_4$ ont été retirés au secondaire par rapport à une topologie à deux deuxièmes branches de commutation 42, tout en reliant le point intermédiaire 90 de l'enroulement secondaire 84 au potentiel supérieur $V_{outp}$ de tension de sortie, et l'homme du métier observera qu'en variante, les interrupteurs $K_1$ et $K_3$ auraient pu être retirés, en reliant alors le point intermédiaire 90 de l'enroulement secondaire 84 au potentiel inférieur $V_{outn}$ de tension de sortie.

L'homme du métier notera que dans l'exemple de la figure 9, l'ensemble piézoélectrique 12 ne peut pas être placé du côté de l'enroulement 82, 84 avec le point intermédiaire 90, car s'il est en série avec un interrupteur, il va être déconnecté sur au moins une demi-période et il ne sera alors pas possible d'appliquer de palier de tension sur cette demi-période. Et si l'ensemble piézoélectrique 12 est connecté en série avec le point intermédiaire 90, comme ce dernier doit échanger une quantité moyenne sensiblement nulle de charges sur une période (équilibre de charge), alors il ne peut pas y avoir de puissance échangée avec la tension de sortie sensiblement constante sur une période de résonance.

Par contre, il est possible d'inverser complètement l'entrée et la sortie pour retrouver un point intermédiaire 90 au primaire et le ou les ensembles piézoélectriques 12 au secondaire.

Dans l'exemple de la figure 10, les tensions au secondaire V2,1, V2,2 et V2,3 sont proportionnelles entre elles selon les rapports m1"= V1/V2,1 ; m2"=V1/V2,2 et m3"= V1/V2,3 relatifs à chacune des sorties du transformateur électrique 80.

Dans l'exemple de la figure 10, le transformateur électrique 80 a été représenté avec un seul enroulement secondaire 84 et des sorties qui exploitent plus ou moins de spires de ce même enroulement secondaire 84.

En variante, le transformateur électrique 80 comporte plusieurs enroulements secondaires 84 complètement indépendants les uns des autres, par exemple afin d'obtenir des tensions secondaires V2,1, V2,2 isolées les unes des autres, comme dans l'exemple de la figure 12.

L'homme du métier observera en outre qu'il est possible, à la manière des figures 17 et 18 du brevet FR 3 086 472, de réguler séparément chacune des sorties en connectant successivement chacune d'elles. Typiquement en découpant les paliers de tension dans lesquels apparaît la tension de sortie en sous-paliers de tension avec les différentes tensions de sortie. Dans ce cas, certains interrupteurs $K_{1,1}$, $K_{2,1}$, $K_{3,1}$, $K_{4,1}$, $K_{1,2}$, $K_{2,2}$, $K_{3,2}$, $K_{4,2}$ du convertisseur 10 de la figure 10 doivent être bidirectionnels en tension, pour pouvoir isoler une sortie alors qu'un courant est fourni sur une autre sortie nécessitant une tension au primaire V1 plus grande.

Dans l'exemple de la figure 10, l'ensemble piézoélectrique 12 est disposé au primaire, et il est mutualisé pour le fonctionnement de toutes les sorties, et le courant de l'ensemble piézoélectrique 12 se partage alors en plusieurs courants de sortie.

En variante, il est possible de connecter un ensemble piézoélectrique 12 à chacune des sorties, comme dans l'exemple de la figure 12. Dans ce cas, il n'est pas indispensable d'utiliser des transistors bidirectionnels en tension pour piloter individuellement chaque sortie. En effet, chacune des tensions de sortie peut être pilotées indépendamment sans passer par des sous-paliers à partir du moment où les cycles pour les tensions de sortie $V_{out\_1}$ et $V_{out\_2}$ sont compatibles pour avoir en commun une même évolution de la tension $V_{pa}$. Par un contrôle différencié des tensions $V_{pb\_1}$ et $V_{pb\_2}$, il est possible d'obtenir des cycles différencié pour les première et deuxième tensions piézoélectriques $V_{p\_out1}$ et $V_{p\_out2}$, et ainsi de contrôler de manière différenciée les tensions de sortie $V_{out\_1}$ et $V_{out\_2}$.

Sur les figures 13 et 14, selon un aspect complémentaire de l'invention et lorsque le convertisseur 10 comprend au moins un couple d'ensembles piézoélectriques 12 connectés à un même enroulement respectif 82, 84, le convertisseur 10 comprend en outre au moins un circuit d'aide à la commutation 50, chaque circuit d'aide à la commutation 50 étant connecté entre les premières extrémités 16 d'un couple respectif d'ensembles piézoélectriques 12, correspondant aux premiers points milieux 38 du premier ensemble de commutation 30 lorsque ledit couple d'ensembles piézoélectriques 12 est connecté au premier ensemble de commutation 30, et correspondant respectivement aux deuxièmes points milieux 48 du deuxième ensemble de commutation 40 lorsque ledit couple d'ensembles piézoélectriques 12 est connecté au deuxième ensemble de commutation 40. Chaque circuit d'aide à la commutation 50 étant configuré pour, via la circulation d'un courant préalablement reçu, décharger une capacité parasite d'au moins un interrupteur 36, 46 de l'ensemble de commutation 30, 40 respectif auquel il est connecté, et respectivement charger au moins une capacité parasite d'un autre interrupteur 36, 46 dudit ensemble de commutation 30, 40.

Dans l'exemple de la figure 13, le convertisseur 10 comprend un unique circuit d'aide à la commutation 50 connecté au premier ensemble de commutation 30.

En variante, non représentée, le convertisseur 10 comprend un unique circuit d'aide à la commutation 50 connecté au deuxième ensemble de commutation 40.

En variante, non représentée, le convertisseur 10 comprend deux circuits d'aide à la commutation 50, un premier circuit d'aide à la commutation étant connecté au premier ensemble de commutation 30 et un deuxième circuit d'aide à la commutation étant connecté au deuxième ensemble de commutation 40.

Chaque circuit d'aide à la commutation 50 est configuré, via la circulation d'un courant $I_{CALC}$ préalablement reçu, pour décharger au moins une capacité parasite d'un interrupteur 36, 46, de préférence un interrupteur à fermer, de l'ensemble de commutation 30, 40 respectif auquel il est connecté ; respectivement pour charger au moins une capacité parasite d'un autre interrupteur 36, 46, de préférence un interrupteur à ouvrir ou à maintenir ouvert, dudit ensemble de commutation 30, 40.

Chacun des interrupteurs dudit ensemble de commutation 30 est ouvert lors de la circulation, par le circuit d'aide à la commutation 50, du courant préalablement reçu.

Suite à cette circulation de courant, le/les interrupteur(s) 36, 46 dont la capacité parasite a été déchargée par le circuit d'aide à la commutation 50 est/sont fermés. Le/les autre(s) interrupteur(s) 36, 46 dont la capacité parasite a été chargée par le circuit d'aide à la commutation 50 reste ouvert. Un courant résiduel du circuit d'aide à la commutation 50 peut continuer de s'écouler.

Chaque circuit d'aide à la commutation 50 comporte par exemple une inductance 70 ; ou un premier ensemble formé de l'inductance 70 et d'une diode 72 connectées en série ; ou un deuxième ensemble formé de l'inductance 70 et d'un condensateur 74 connectés en série ; ou encore un élément piézoélectrique additionnel 76, comme représenté sur la figure 14.

Chaque circuit d'aide à la commutation 50 est par exemple une inductance 70, l'inductance 70 étant de préférence constituée d'une bobine et d'un circuit magnétique. En variante, chaque circuit d'aide à la commutation 50 est en forme du premier ensemble de l'inductance 70 et de la diode 72 connectées en série, et de préférence constitué dudit premier ensemble de l'inductance 70 et de la diode 72. En variante encore, chaque circuit d'aide à la commutation 50 est en forme du deuxième ensemble de l'inductance 70 et du condensateur 74 connectés en série, et de préférence constitué dudit deuxième ensemble de l'inductance 70 et du condensateur 74. En variante encore, chaque circuit d'aide à la commutation 50 est en forme de l'élément piézoélectrique additionnel 76, et de préférence constitué de l'élément piézoélectrique additionnel 76.

En variante encore, le transformateur électrique 80 est dimensionné de sorte à présenter un comportement inductif sous la forme d'une inductance parasite équivalente placée entre les bornes de l'enroulement primaire 82 et/ou entre celles de l'enroulement secondaire 84 du transformateur. Cette inductance parasite, généralement appelée inductance magnétisante, permet alors d'assurer cette fonction de circuit d'aide à la commutation 50. Une telle inductance magnétisante est illustrée en planche 15 de la présentation intitulée « Transformateur monophasé » de Abdallah Darkawi du 19 février 2019.

Dans l'exemple de réalisation où le circuit d'aide à la commutation 50 est en forme de l'inductance 70 seule, l'inductance 70 voit son courant croitre sur une demi-période, i.e. lorsque la tension à ses bornes est positive ; puis son courant décroitre sur l'autre demi-période, i.e. lorsque la tension à ses bornes est négative. Cet exemple de réalisation du circuit d'aide à la commutation 50 nécessite de préférence que la tension aux bornes de l'inductance 70 soit de moyenne sensiblement nulle, au risque sinon d'avoir une dérive en courant. Si le circuit d'aide à la commutation 50 est connecté au deuxième ensemble 40, en particulier entre les deuxièmes points milieux 48, la tension aux bornes de l'inductance 70 est la tension $V_{pb}$. Corollairement, si le circuit d'aide à la commutation 50 est connecté au premier ensemble 30, en particulier entre les premiers points milieux 38, la tension aux bornes de l'inductance 70 est la tension $V_{pa}$.

La variante où le circuit d'aide à la commutation 50 est en forme de l'inductance 70 et de la diode 72 connectées en série, permet de charger l'inductance 70 uniquement sur une demi-période avec la bonne polarité, en particulier pour des cycles où le courant $I_{CALC}$ est reçu au cours d'une période temporelle avec une seule polarité. En particulier, la diode 72 permet alors d'éviter de charger l'inductance 70 avec un courant inverse. Ce fonctionnement unidirectionnel en courant permet aussi de réduire le courant efficace vu par l'inductance 70 et donc les pertes. Par ailleurs, le circuit d'aide à la commutation 50 selon cette variante n'est pas sensible à la présence d'une composante continue à partir du moment où la composante continue est dans le sens d'un blocage de la diode 72.

La variante où le circuit d'aide à la commutation 50 est en forme de l'inductance 70 et du condensateur 74 connectés en série, permet - par rapport à l'exemple de l'inductance 70 seule - de réduire, voire d'éliminer une composante continue éventuelle. Néanmoins, le condensateur 74 peut être assez volumineux. En effet, la tension aux bornes du condensateur 74 doit évoluer peu, i.e. dans une faible proportion, par rapport à la tension d'entrée $V_{in}$ ou à la tension de sortie $V_{out}$, par exemple avoir une amplitude inférieure à 50% de la tension d'entrée $V_{in}$ ou de sortie $V_{out}$.

Selon la variante où le circuit d'aide à la commutation 50 est en forme de l'élément piézoélectrique additionnel 76, à partir du moment où le pilotage du convertisseur 10 s'effectue entre la fréquence de résonance et d'antirésonance de l'élément piézoélectrique additionnel 76, ce dernier se met à osciller et à produire un courant $I_{CALC}$ sensiblement en quadrature avec la tension à ses bornes, telle que la tension $V_{pb}$ si l'élément piézoélectrique additionnel 76 est connecté au deuxième ensemble 40 entre les deuxièmes points milieux 48, ou encore la tension $V_{pa}$ si l'élément piézoélectrique additionnel 76 est connecté au premier ensemble 30 entre les premiers points milieux 38. Le courant $I_{CALC}$ passe alors par un extrema, ce qui permet d'assurer la fonction d'inversion de la tension $V_{pb}$, ou respectivement de la tension $V_{pa}$.

L'élément piézoélectrique additionnel 76 est typiquement au moins 3 fois plus petit que le ou les éléments piézoélectriques 15 du convertisseur 10, l'élément piézoélectrique additionnel 76 n'ayant qu'à charger/décharger les capacités parasites des interrupteurs 36, 46. La capacité parasite des interrupteurs 36, 46 est en effet considérée comme étant au moins trois fois inférieure à la capacité de référence $C_0$ du ou des éléments piézoélectriques 15 du convertisseur 10. Cette variante où le circuit d'aide à la commutation 50 est en forme de l'élément piézoélectrique additionnel 76 est insensible à une éventuelle composante continue (quelle que soit sa polarité), et le circuit d'aide à la commutation 50 est apte à être connecté aussi bien au premier ensemble 30 (tension $V_{pa}$) qu'au deuxième ensemble 40 (tension $V_{pb}$).

Autrement dit, la capacité de référence de l'élément piézoélectrique additionnel 76 est au moins trois fois inférieure à la capacité de référence $C_0$ de chaque ensemble piézoélectrique 12 connecté entre des premier 38 et deuxième 48 points milieux respectifs.

Sur la figure 15, selon un autre aspect complémentaire de l'invention et lorsque le convertisseur 10 comprend au moins un couple d'ensembles piézoélectriques 12 connectés à un même enroulement respectif 82, 84, le convertisseur 10 comprend en outre un interrupteur complémentaire 28 connecté directement entre les premières extrémités 16 dudit couple d'ensembles piézoélectriques 12, lesdites premières extrémités 16 reliées directement entre elles via l'interrupteur complémentaire 28 étant connectées à un même ensemble de commutation respectif 30, 40.

Dans l'exemple de la figure 15, le convertisseur 10 comprend un seul interrupteur complémentaire 28 connecté directement entre les premières extrémités 16 du couple d'ensembles piézoélectriques 12 connecté à l'enroulement primaire 82.

En variante non représentée, le convertisseur 10 comprend un seul interrupteur complémentaire 28 connecté directement entre les premières extrémités 16 du couple d'ensembles piézoélectriques 12 connecté à l'enroulement secondaire 84.

En variante encore, non représentée, le convertisseur 10 comprend deux interrupteurs complémentaires 28, à savoir un premier interrupteur complémentaire 28 connecté directement entre les premières extrémités 16 du couple d'ensembles piézoélectriques 12 connecté à l'enroulement primaire 82 et un deuxième interrupteur complémentaire 28 connecté directement entre les premières extrémités 16 du couple d'ensembles piézoélectriques 12 connecté à l'enroulement secondaire 84.

En variante encore, non représentée, et lorsque le convertisseur 10 comprend plusieurs couples d'ensembles piézoélectriques 12, chacun connecté à un enroulement respectif 82, 84, le convertisseur 10 comprend de préférence un interrupteur complémentaire 28 pour chaque couple d'ensembles piézoélectriques 12, chaque interrupteur complémentaire 28 étant alors connecté entre les premières extrémités 16 d'un couple respectif.

Dans l'exemple de la figure 15, l'interrupteur complémentaire 28 est également noté $K_9$.

Chaque interrupteur complémentaire 28 est de préférence un interrupteur bidirectionnel en tension. Chaque interrupteur complémentaire 28 comprend par exemple deux interrupteurs unidirectionnels, i.e. monodirectionnels, en tension placés tête-bêche en série. Chaque interrupteur unidirectionnel comporte par exemple un transistor, ou une diode, ou encore un transistor et une diode en antiparallèle, non représentés. Chaque interrupteur unidirectionnel est de préférence constitué du transistor, ou de la diode, ou encore du transistor et de la diode en antiparallèle.

L'homme du métier observera que chaque interrupteur complémentaire 28 est en variante un interrupteur monodirectionnel en tension.

Selon cet aspect complémentaire de l'invention, le dispositif électronique de pilotage 20 est configuré en outre pour, lors d'au moins une phase à tension sensiblement constante, commander au moins un interrupteur complémentaire 28 respectif en position fermée.

L'homme du métier comprendra alors que lorsque le convertisseur 10 comprend un interrupteur complémentaire 28 respectif connecté directement entre les premières extrémités 16 d'un couple respectif d'ensembles piézoélectriques 12 connecté à l'enroulement primaire 82, la commande en position fermée dudit interrupteur complémentaire 28 permet de forcer à la valeur nulle la tension $V_{pa}$ entre lesdites premières extrémités 16.

De manière analogue, lorsque le convertisseur 10 comprend un interrupteur complémentaire 28 respectif connecté directement entre les premières extrémités 16 d'un couple respectif d'ensembles piézoélectriques 12 connecté à l'enroulement secondaire 84, alors la commande en position fermée dudit interrupteur complémentaire 28 permet de forcer à la valeur nulle la tension $V_{pb}$ entre les premières extrémités 16.

De manière analogue encore, lorsque le convertisseur 10 comprend deux interrupteurs complémentaires 28 connectés aux premières extrémités 16 de deux couples respectifs d'ensembles piézoélectriques 12 connectés d'une part à l'enroulement primaire 82 et d'autre part à l'enroulement secondaire 84, c'est-à-dire à la fois le premier interrupteur complémentaire 28 connecté directement entre les premières extrémités 16 d'un couple respectif d'ensembles piézoélectriques 12 connecté à l'enroulement primaire 82 et un deuxième interrupteur complémentaire 28 connecté directement entre les premières extrémités 16 de l'autre couple d'ensembles piézoélectriques 12 connecté à l'enroulement secondaire 84, alors la commande en position fermée de ces premier et deuxième interrupteurs complémentaires 28 permet de forcer à la fois la tension $V_{pa}$ à la valeur nulle et la tension $V_{pb}$ à la valeur nulle, et donc de forcer la tension piézoélectrique totale $V_p$ des deux couples d'ensembles piézoélectriques 12 à la valeur nulle.

**Revendications**

1. Système électronique de conversion d'énergie électrique (5) apte à convertir une ou plusieurs tensions d'entrée ($V_{in}$ ; $V_{in\_k}$) en une ou plusieurs tensions de sortie ($V_{out}$ ; $V_{out\_j}$), le système de conversion (5) comprenant :

    - un convertisseur d'énergie électrique (10) configuré pour délivrer N tension(s) de sortie distincte(s) ($V_{out}$ ; $V_{out\_j}$), à partir de E tension(s) d'entrée distincte(s) ($V_{in}$ ; $V_{in\_k}$), E et N étant chacun un nombre entier supérieur ou égal à 1, le convertisseur (10) comprenant :

        + E premier(s) ensemble(s) de commutation (30), chacun étant associé à une tension d'entrée respective

($V_{in}$ ;$V_{in\_k}$) et comportant au moins deux premiers interrupteurs (36), chaque premier interrupteur (36) étant connecté à une borne (34) d'application de la tension d'entrée respective ($V_{in}$ ;$V_{in\_k}$) ;

+ N deuxième(s) ensemble(s) de commutation (40), chacun étant associé à une tension de sortie respective ($V_{out}$;$V_{out\_j}$) et comportant au moins deux deuxièmes interrupteurs (46), chaque deuxième interrupteur (46) étant connecté à une borne (44) de fourniture de la tension de sortie respective ($V_{out}$ ;$V_{out\_j}$) ;

+ au moins un ensemble piézoélectrique (12), chacun étant connecté à un interrupteur parmi les premiers (36) et deuxièmes (46) interrupteurs, et comportant au moins un élément piézoélectrique (15) ;

- un dispositif électronique (20) de pilotage du convertisseur d'énergie électrique (10), le dispositif électronique de pilotage (20) étant configuré pour commander, lors d'un cycle respectif de résonance du ou des ensembles piézoélectriques (12), une commutation de chacun des premiers (36) et deuxièmes (46) interrupteurs pour alterner des phases à tension sensiblement constante aux bornes du ou des ensembles piézoélectriques (12) et des phases à charge sensiblement constante aux bornes dudit ou desdits ensembles piézoélectriques (12),

**caractérisé en ce que** le convertisseur (10) comprend en outre un transformateur électrique (80) comportant, au moins un enroulement primaire (82) et au moins un enroulement secondaire (84), chaque enroulement primaire (82) étant relié à un premier ensemble de commutation (30), chaque enroulement secondaire (84) étant relié à un deuxième ensemble de commutation (40), et chaque ensemble piézoélectrique (12) est connecté entre un interrupteur (36 ; 46) et un enroulement (82 ; 84) respectifs.

2. Système (5) selon la revendication 1, dans lequel chaque ensemble piézoélectrique (12) est connecté entre un premier interrupteur (36) et un enroulement primaire (82) ou bien entre un deuxième interrupteur (46) et un enroulement secondaire (84).

3. Système (5) selon la revendication 1 ou 2, dans lequel chaque enroulement (82, 84) est connecté à au moins un ensemble piézoélectrique (12) ou bien présente entre ses extrémités une tension de valeur moyenne sensiblement nulle sur un cycle respectif de résonance, le dispositif de pilotage (20) étant alors configuré pour commander les interrupteurs (36 ;46) de l'ensemble de commutation (30 ; 40) connecté audit enroulement (82 ; 84) de manière à obtenir ladite tension de valeur moyenne sensiblement nulle.

4. Système (5) selon l'une quelconque des revendications 1 à 3, dans lequel le convertisseur (10) comprend plusieurs ensembles piézoélectriques (12), et chaque enroulement (82, 84) est connecté à au moins un ensemble piézoélectrique (12).

5. Système (5) selon l'une quelconque des revendications 1 à 3, dans lequel le convertisseur (10) comprend un seul ensemble piézoélectrique (12) connecté à un enroulement respectif (82 ; 84), et le ou chaque autre enroulement (84 ; 82) présente entre ses extrémités (88) une tension de valeur moyenne sensiblement nulle sur un cycle respectif de résonance.

6. Système (5) selon l'une quelconque des revendications précédentes, dans lequel au moins un premier ensemble de commutation (30) est en forme d'un premier pont de commutation comportant au moins une première branche de commutation (32), chaque première branche de commutation (32) étant connectée entre deux bornes (34) d'application d'une tension d'entrée respective ($V_{in}$ ;$V_{in\_k}$) et comportant au moins deux premiers interrupteurs (36) connectés en série et reliés entre eux en un premier point milieu (38);

chaque premier ensemble de commutation (30) étant de préférence en forme d'un premier pont de commutation respectif.

7. Système (5) selon la revendication 6, dans lequel au moins un premier ensemble de commutation (30) comporte deux premières branches de commutation (32) ;

chaque premier ensemble de commutation (30) comportant de préférence deux premières branches de commutation (32).

8. Système (5) selon la revendication 6 ou 7, dans lequel un ensemble piézoélectrique (12) est connecté entre un premier point milieu (38) et un enroulement primaire (82) respectif.

9. Système (5) selon l'une quelconque des revendications précédentes, dans lequel au moins un deuxième ensemble de commutation (40) est en forme d'un deuxième pont de commutation comportant au moins une deuxième branche de commutation (42), chaque deuxième branche de commutation (42) étant connectée entre deux bornes (44) de fourniture d'une tension de sortie respective ($V_{out}$ ;$V_{out\_j}$) et comportant au moins deux deuxièmes interrupteurs (46) connectés en série et reliés entre eux en un deuxième point milieu (48) ;

chaque deuxième ensemble de commutation (40) étant de préférence en forme d'un deuxième pont de commutation respectif ;

au moins un deuxième ensemble de commutation (40) comportant de préférence deux deuxièmes branches de commutation (42) ;

chaque deuxième ensemble de commutation (40) comportant de préférence encore deux deuxièmes branches de commutation (42).

10. Système (5) selon la revendication 10, dans lequel un ensemble piézoélectrique (12) est connecté entre un deuxième point milieu (48) et un enroulement secondaire (84) respectif.

11. Système (5) selon l'une quelconque des revendications précédentes, dans lequel un enroulement (82, 84) comporte, entre ses extrémités (88), au moins un point intermédiaire (90) connecté à un ensemble de commutation respectif (30, 40) ou bien à une borne respective d'application de tension d'entrée (34) ou de fourniture de tension de sortie (44).

12. Système (5) selon l'une quelconque des revendications précédentes, dans lequel le convertisseur (10) comprend un couple d'ensembles piézoélectriques (12) connectés à un même enroulement respectif (82, 84), et en outre un interrupteur complémentaire (28) connecté directement entre des extrémités (16) dudit couple d'ensembles piézoélectriques (12), lesdites extrémités (16) reliées directement entre elles via l'interrupteur complémentaire (28) étant connectées à un même ensemble de commutation respectif (30 ; 40).

13. Système (5) selon l'une quelconque des revendications précédentes, dans lequel le convertisseur (10) comprend un couple d'ensembles piézoélectriques (12) connectés à un même enroulement respectif (82, 84), et en outre un circuit d'aide à la commutation (50) connecté entre des extrémités (16) dudit couple d'ensembles piézoélectriques (12), lesdites extrémités (16) reliées entre elles via le circuit d'aide à la commutation (50) étant connectées à un même ensemble de commutation respectif (30 ; 40), le circuit d'aide à la commutation (50) étant configuré pour, via la circulation d'un courant préalablement reçu, décharger une capacité parasite d'au moins un interrupteur (36 ; 46) de l'ensemble de commutation respectif (30 ; 40) auquel il est connecté, et respectivement charger au moins une capacité parasite d'un autre interrupteur (36 ; 46) dudit ensemble de commutation (30 ; 40).

14. Système (5) selon la revendication 13, dans lequel le circuit d'aide à la commutation (50) comporte un élément choisi parmi le groupe consistant en : une inductance (70) ; un premier ensemble formé d'une inductance (70) et d'une diode (72) connectées en série ; un deuxième ensemble formé d'une inductance (70) et d'un condensateur (74) connectés en série ; et un élément piézoélectrique additionnel (76) ;

le circuit d'aide à la commutation (50) étant de préférence constitué d'un élément choisi parmi ledit groupe ;

l'inductance (70) étant de préférence encore en forme d'une inductance parasite de l'enroulement respectif (82, 84) auquel est connecté le couple d'ensembles piézoélectriques (12).

15. Système (5) selon l'une quelconque des revendications précédentes, dans lequel le transformateur électrique (80) est un transformateur à air ou un transformateur magnétique, le transformateur magnétique comportant en outre un noyau magnétique (86), chaque enroulement (82, 84) étant alors agencé autour du noyau (86) ;

le transformateur électrique (80) étant par exemple un autotransformateur.

FIG.1

$Vp = Vp1 + Vp3 + mVp2 + mVp4$

**FIG.2**

$Vp=Vp1+Vp3$

**FIG.3**

$$Vp=Vp1+Vp3+mVp2+mVp4$$

FIG.4

EP 4 203 287 A1

**FIG.5**

**FIG.6**

**FIG.7**

$Vp = Vp1 + mVp2$

**FIG.8**

FIG.9

FIG.10

FIG.11

## FIG.12

## FIG.13

EP 4 203 287 A1

FIG.14

**FIG.15**

Europäisches
Patentamt

European
Patent Office

Office européen
des brevets

# RAPPORT DE RECHERCHE EUROPEENNE

Numéro de la demande

EP 22 21 4904

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 081 438 A (SAINT-PIERRE ROLAND SYLVERE [US] ET AL) 27 juin 2000 (2000-06-27) * abrégé * * figures 1-12 * * colonne 2, ligne 10 - colonne 7, ligne 60 * | 1-15 | INV. H02M3/335 H02M3/00 |
| X | EP 2 273 660 A1 (MIDAS WEI TRADING CO LTD [CN]; CHAMPION ELITE CO LTD [VG]) 12 janvier 2011 (2011-01-12) * abrégé * * alinéa [0001] - alinéa [0053]; figures 1-19 * | 1-15 | |
| X | US 2010/289422 A1 (WEI TAO-CHIN [TW]) 18 novembre 2010 (2010-11-18) * abrégé * * alinéa [0001] - alinéa [0035]; figures 1-10 * | 1-15 | |
| A | LI WUHUA ET AL: "Topology Review and Derivation Methodology of Single-Phase Transformerless Photovoltaic Inverters for Leakage Current Suppression", IEEE TRANSACTIONS ON INDUSTRIAL ELECTRONICS, IEEE SERVICE CENTER, PISCATAWAY, NJ, USA, vol. 62, no. 7, 1 juillet 2015 (2015-07-01), pages 4537-4551, XP011581623, ISSN: 0278-0046, DOI: 10.1109/TIE.2015.2399278 [extrait le 2015-05-15] * abrégé * * figure 21d * | 12 | **DOMAINES TECHNIQUES RECHERCHES (IPC)** H02M |

-/--

Le présent rapport a été établi pour toutes les revendications

| Lieu de la recherche | Date d'achèvement de la recherche | Examinateur |
|---|---|---|
| La Haye | 24 janvier 2023 | Adami, Salah-Eddine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................
& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

**EP 22 21 4904**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ZHANG HAILIN ET AL: "Analysis and Compensation of Dead-Time Effect of a ZVT PWM Inverter Considering the Rise- and Fall-Times", APPLIED SCIENCES, vol. 6, no. 11, 9 novembre 2016 (2016-11-09), page 344, XP055944032, DOI: 10.3390/app6110344 * abrégé * * section 2; figures 1-3 * | 13,14 | |
| A | EP 3 627 687 A1 (COMMISSARIAT ENERGIE ATOMIQUE [FR]) 25 mars 2020 (2020-03-25) * abrégé * * alinéa [0194] - alinéa [0204]; figure 20 * | 1-15 | |
| A | Pollet Benjamin: "Convertisseurs DC-DC piézoélectrique avec stockage provisoire d'énergie sous forme mécanique", , 15 novembre 2019 (2019-11-15), pages 1-169, XP055862319, Extrait de l'Internet: URL:https://tel.archives-ouvertes.fr/tel-0 2415837/document [extrait le 2021-11-16] * abrégé * * partie 5.2.2.2; figure 4.15 * | 1-15 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 24 janvier 2023 | Adami, Salah-Eddine |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 21 4904

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-01-2023

| Document brevet cité au rapport de recherche | Date de publication | Membre(s) de la famille de brevet(s) | Date de publication |
|---|---|---|---|
| US 6081438 A | 27-06-2000 | AUCUN | |
| EP 2273660 A1 | 12-01-2011 | BR PI0904267 A2 | 01-02-2011 |
| | | CA 2682599 A1 | 22-11-2010 |
| | | DK 2273660 T3 | 19-03-2018 |
| | | EP 2273660 A1 | 12-01-2011 |
| | | ES 2661189 T3 | 27-03-2018 |
| | | HR P20180367 T1 | 20-04-2018 |
| | | HU E036611 T2 | 30-07-2018 |
| | | JP 5317884 B2 | 16-10-2013 |
| | | JP 2010273528 A | 02-12-2010 |
| | | KR 20100126160 A | 01-12-2010 |
| | | LT 2273660 T | 26-03-2018 |
| | | NO 2273660 T3 | 12-05-2018 |
| | | PL 2273660 T3 | 31-07-2018 |
| | | PT 2273660 T | 21-03-2018 |
| | | TW 201042898 A | 01-12-2010 |
| | | US 2010296315 A1 | 25-11-2010 |
| US 2010289422 A1 | 18-11-2010 | JP 3154148 U | 08-10-2009 |
| | | KR 20100011474 U | 24-11-2010 |
| | | TW M366858 U | 11-10-2009 |
| | | US 2010289422 A1 | 18-11-2010 |
| EP 3627687 A1 | 25-03-2020 | EP 3627687 A1 | 25-03-2020 |
| | | FR 3086471 A1 | 27-03-2020 |
| | | US 2020098968 A1 | 26-03-2020 |

EPO FORM P0460

Pour tout renseignement concernant cette annexe : voir Journal Officiel de l'Office européen des brevets, No.12/82

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3086471 A1
- FR 3086472 A1
- FR 2107345
- FR 2112925
- FR 2112926
- FR 2112933
- FR 3086472

**Littérature non-brevet citée dans la description**

- **BENJAMIN POLLET.** *Convertisseurs DC-DC piézoélectrique avec stockage provisoire d'énergie sous forme mécanique*
- **ABDALLAH DARKAWI.** *Transformateur monophasé,* 19 Février 2019